(19) **Europäisches Patentamt / European Patent Office / Office européen des brevets**

(11) **EP 1 806 849 A1**

(12) **EUROPEAN PATENT APPLICATION**
published in accordance with Art. 158(3) EPC

(43) Date of publication:
**11.07.2007 Bulletin 2007/28**

(51) Int Cl.:
**H03M 13/09** (2006.01)

(21) Application number: **04792226.5**

(86) International application number:
**PCT/JP2004/014958**

(22) Date of filing: **08.10.2004**

(87) International publication number:
**WO 2006/040805 (20.04.2006 Gazette 2006/16)**

(84) Designated Contracting States:
**DE FR GB**

(71) Applicant: **MITSUBISHI ELECTRIC CORPORATION**
**Chiyoda-ku**
**Tokyo 100-8310 (JP)**

(72) Inventor: **MATSUMOTO, Wataru,**
**c/o Mitsubishi Electric Corporation**
**Tokyo 1008310 (JP)**

(74) Representative: **Pfenning, Meinig & Partner GbR**
**Patent- und Rechtsanwälte**
**Theresienhöhe 13**
**80339 München (DE)**

(54) **CHECK MATRIX GENERATING APPARATUS AND COMMUNICATION APPARATUS**

(57) A check matrix generating apparatus calculates a parameter for pseudo-random-number permutation matrices using a predetermined information length, a coding rate, and a maximum column degree, generates the pseudo-random-number permutation matrices from the calculated parameter for the pseudo-random-number permutation matrices by using a pseudo-random-number sequence and a Latin square matrix, determines, as a parameter, a combination of degree distributions which can be adopted for optimization of a degree distribution of generation of a check matrix which can be formed with the pseudo-random-number permutation matrices, using the predetermined information length, coding rate, and maximum column degree, optimizes the degree distribution of generation of a check matrix under a restriction condition based on the determined combination of degree distributions which can be adopted, and arranges the generated pseudo-random-number permutation matrices according to the optimized degree distribution of generation of the check matrix so as to generate the check matrix for low-density parity-check codes.

FIG.6

Start

Input an Information Length, a Coding Rate, and a Maximum Column Degree — ST11

Calculate Parameters for Pseudo-Random Number Permutation Matrices — ST12

Generate the Pseudo-Random Number Permutation Matrices Using a Pseudo-Random Number Sequence and a Latin Square Matrix — ST13

Determine, As a Parameter, a Combination of Degree Distributions Which Can Be Adopted for Optimization of the Degree Distribution of Generation of a Check Matrix — ST14

Optimize the Degree Distribution by Means of the Density Evolution Method by Imposing, As a Restriction Condition, the Combination of Degree Distributions Which Can Be Adopted, on the Optimization of the Degree Distribution of Generation of a Check Matrix — ST15

Arrange the Pseudo-Random Number Permutation Matrices So As To Generate a Check Matrix — ST16

End

**Description**

Field of the Invention

The present invention relates to a check matrix generating apparatus which adopts a low-density parity-check (LDPC: Low-Density Parity-Check) code as an error correcting code, and a communication apparatus equipped with this check matrix generating apparatus. More particularly, it relates to a check matrix generating apparatus which can search for a deterministic check matrix for LDPC codes having stable characteristics, and a communication apparatus equipped with this check matrix generating apparatus.

Background of the Invention

Hereafter, a prior art check matrix generation method for LDPC codes will be explained. In a prior art LDPC coding/decoding system, a communication apparatus on a transmit side of the system is provided with an encoder and a modulator, and a communication apparatus on a receive side of the system is provided with a demodulator and a decoder. Hereafter, a flow of coding and decoding at the time of using LDPC codes will be explained before an explanation about the prior art check matrix generation method for LDPC codes is made.

First, the encoder on the transmit side of the system generates a check matrix H according to a prior art method which will be mentioned below. The encoder then calculates a generator matrix G on the basis of the following conditions:
G: KxN matrix (K is an information length and N is a code length)
$GH^T=0$ (the superscript T indicates that the matrix is the transpose of the given matrix).

After that, the encoder receives a message $(m_1 m_2 ... m_K)$ having the information length K, and generates a code word C using the above-mentioned generator matrix G.

$$C = (m_1 \ m_2 \ ... \ m_K) \, G$$

$$= (c_1 \ c_2 \ ... \ c_N) \quad (\text{where } H(c_1 \ c_2 \ ... \ c_N)^T = 0)$$

The modulator then performs a digital modulation, such as BPSK (Binary Phase Shift Keying), QPSK (Quadrature Phase Shift Keying), or multiple-value QAM (Quadrature Amplitude Modulation), on the generated code word C, and transmits the digital-modulated code word C.

On the other hand, on the receive side of the system, the demodulator performs a digital demodulation, such a BPSK, QPSK, or multiple-value QAM, on the modulated signal which the demodulator has received via a communication path, and the decoder performs iteration decoding based on the "sum-product algorithm" on the demodulated result which is LDPC-coded and outputs an estimation result (which corresponds to the original message $m_1 \, m_2 \, ... \, m_k$).

Next, the prior art check matrix generation method for LDPC codes will be explained concretely.

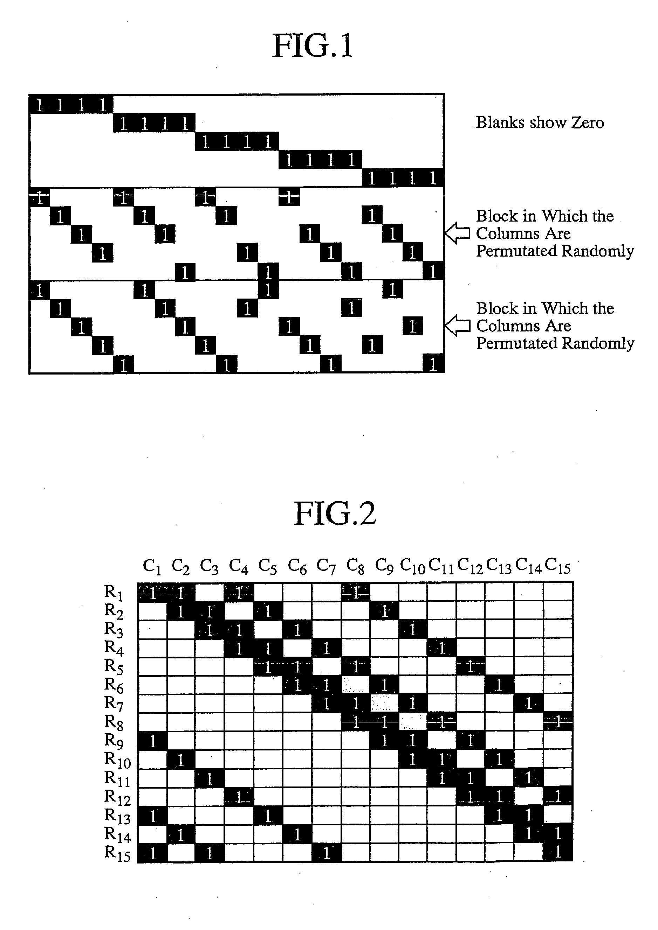

Fig. 1 is a diagram showing a prior art check matrix for LDPC codes which is proposed by nonpatent reference 1. The matrix shown in Fig. 1 is a matrix in which every element has a binary value of "1" or "0", and rectangular regions corresponding to all elements of "1" are filled in with black. In this figure, all other blank portions correspond to elements of "0." In this matrix, the number of "1s" in each row (this number is expressed as the degree of row) is 4 and the number of "1s" in each column (this number is expressed as the degree of column) is 3, and the degrees of column in all the columns and the degrees of raw in all the rows are equal. In general, this matrix is called "Regular-LDPC code." In the coding disclosed in nonpatent reference 1, the matrix is divided into, for example, three blocks, as shown in Fig. 1, and random permutation is performed on a second block and a third block.

However, because there is no predetermined rule in this random permutation, a search which requires much time to conduct using a computer must be performed in order to find out a code having better characteristics.

For example, a method of making it possible to generate a matrix definitely without having to make a search using a computer, and using a Euclidean-geometry code as a LDPC code indicating relatively-stable and good characteristics is proposed by nonpatent reference 2. In this method, a "Regular-LDPC code" which is comprised of a regular ensemble (ensemble) is explained.

According to nonpatent reference 2, a method of generating a check matrix for LDPC codes using a Euclidean-geometry code $EG(2,2^6)$ which is a type of a limited geometry code is proposed, and characteristics close to 1.45dB from the Shannon limit are provided at an error rate of $10^{-4}$ points.
Fig. 2 is a diagram showing the structure of a Euclidean-geometry code $EG(2,2^2)$, and shows a "Regular-LDPC code" structure in which each row has a degree of 4 and each column has a degree of 4.

Therefore, in a case of a Euclidean-geometry code $EG(m,2^s)$, the characteristics of the code are specified as follows, where, EG(m,2$^s$) is an m-dimensional Euclidean-geometry code over GF(2$^s$).

| | |
|---|---|
| Code length: | $N=2^{2s}-1$ |
| Redundant bit length: | $N-K=3^s-1$ |
| Information length: | $K=2^{2s}-3^s$ |
| Minimum distance: | $d_{min}=2^s+1$ |
| Density: | $r=2^s/(2^{2s}-1)$ |

As can be seen from Fig. 2, a Euclidean-geometry code has a structure in which the positions of "1s" in each row are cyclically shifted by 1 as the row number is incremented by 1, and has the property of being able to be formed easily and definitely.

In accordance with the check matrix generation method disclosed in nonpatent reference 2, the degree of row and the degree of column are changed on the basis of the above-mentioned Euclidean-geometry code, and the rows and columns are extended if needed. For example, when the degree of column of EG(2,2$^2$) is reduced to 2, in accordance with nonpatent reference 2, four 1s in each column are separated into two sets on every other 1.

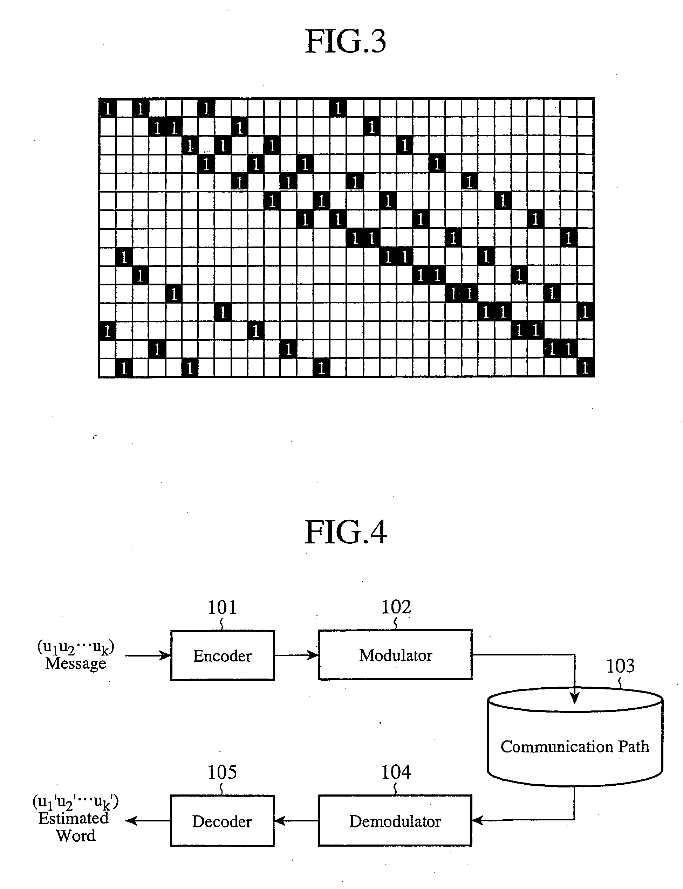

Fig. 3 is a diagram showing an example in which the degree of column of the Euclidean-geometry code is regularly reduced from 4 to 2.

On the other hand, nonpatent reference 3 reports that "Irregular-LDPC codes" have characteristics of which are better than those of the above-mentioned "Regular-LDPC codes." The characteristics of irregular-LDPC codes are theoretically analyzed by nonpatent reference 4 and nonpatent reference 5. An "Irregular-LDPC code" as mentioned above is an LDPC code in which both the degrees of columns and the degrees of rows are not uniform or either of them is not uniform.

In particular, in accordance with nonpatent reference 5, the "Sum-Product algorithm" for LDPC codes is analyzed assuming that the logarithmic likelihood ratio (LLR) of the input and output of an iteration decoder can be approximated with a Gaussian distribution, and the ensemble of the degrees of rows which exhibit good characteristics and the degrees of columns which exhibit good characteristics is calculated.

[Nonpatent reference 1] R.G. Gallager. "Low-Density Parity Check Codes." IRE Trans. On IT pp21-28, January 1962.

[Nonpatent reference 2] Y. Kou, S. Lin, and M. P. C. Fossorier, "Low Density Parity Check Codes Based on Finite Geometries: A Rediscovery and New Results," IEEE Trans. Inform. Theory, vol.47, No.2, pp.2711-2736, Feb. 2001.

[Nonpatent reference 3] M. G. Luby, M. Mitzenmacher, M. A. Shokrollahi, and D. A. Spielman, "Improved Low-Density Parity-Check Codes Using Irregular Graphs and Belief Propagation," Proceedings of 1998 IEEE International Symposium on Information Theory, pp. 171, Cambridge, Mass., August 16-21, 1998.

[Nonpatent reference 4] T. J. Richardson and R. Urbanke, "The capacity of low-density parity-check codes under message-passing decoding," IEEE Trans. Inform. Theory, vol.47, No.2, pp.599-618, Feb. 2001.

[Nonpatent reference 5] S.-Y. Chung, T. J. Richardson, and R. Urbanke, "Analysis of Sum-Product Decoding of Low-Density Parity-Check Codes Using a Gaussian Approximation, " IEEE Trans. Inform. Theory, vol.47, No.2, pp.657-670, Feb. 2001.

A problem with prior art check matrix generation methods for LDPC codes which are practiced as mentioned above is that in most cases a minimum cycle (referred to as an inner diameter) of a check matrix is about 6 (in the case of Figs. 2 and 3, it is 6), the Hamming distance of the code word increases with increase in the cycle of the check matrix, and the error correction capabilities of the prior art check matrix generation methods are inadequate from the viewpoint of general analysis results which usually provide good characteristics when using the Sum-product decoding method.

The present invention is made in order to solve the above-mentioned problem, and it is therefore an object of the present invention to a check matrix generating apparatus for LDPC codes which can easily generate a check matrix for Irregular-LDPC codes which is deterministic, which have stable characteristics, which has a good error correction capability, and which supports various ensembles, various code lengths, and various coding rates in a short time, and a communication apparatus equipped with this check matrix generating apparatus.

In this specification, "deterministic" means that both of the transmit and receive sides have a common algorithm and derives the same result with limited features, and, in the case of the present invention, means that a check matrix for LDPC codes can be generated with limited features, such as a coding rate and a code length.

Disclosure of the Invention

In accordance with the present invention, there is provided a check matrix generating apparatus including: an information length, coding rate, and maximum column degree input unit for inputting a predetermined information length, a coding rate, and a maximum column degree; a pseudo-random-number permutation matrix parameter calculating unit for calculating a parameter for below-mentioned pseudo-random-number permutation matrices using the above-mentioned inputted predetermined information length, the above-mentioned inputted coding rate, and the above-mentioned inputted maximum column degree; a pseudo-random-number permutation matrix generating unit for generating the above-mentioned pseudo-random-number permutation matrices from the calculated parameter for the above-mentioned pseudo-random-number permutation matrices by using a pseudo-random-number sequence and a Latin square matrix; a degree distribution optimization parameter calculating unit for determining, as a parameter, a combination of degree distributions which can be adopted for optimization of a degree distribution of generation of a check matrix which can be formed with the above-mentioned pseudo-random-number permutation matrices, using the above-mentioned inputted predetermined information length, the above-mentioned inputted coding rate, and the above-mentioned inputted maximum column degree; a degree distribution optimizing unit for optimizing the degree distribution of generation of the check matrix by means of a density evolution method by imposing, as a restriction condition, the above-mentioned determined combination of degree distributions which can be adopted, on the optimization of the degree distribution of generation of the check matrix; and a check matrix generating unit for arranging the above-mentioned generated pseudo-random-number permutation matrices according to the above-mentioned optimized degree distribution of generation of the check matrix so as to generate the check matrix for low-density parity-check codes.

The present invention therefore offers an advantage of being able to easily generate a check matrix for Irregular-LDPC codes which is deterministic, which have stable characteristics, which has a good error correction capability, and which supports various ensembles, various code lengths, and various coding rates in a short time.

Brief Description of the Figures

[Fig. 1] Fig. 1 is a diagram showing a prior art check matrix for LDPC codes;
[Fig. 2] Fig. 2 is a diagram showing the structure of a Euclidean geometry code EG(2,2$^2$);
[Fig. 3] Fig. 3 is a diagram showing an example in which the degree of column of the Euclidean-geometry code is regularly reduced from 4 to 2;
[Fig. 4] Fig. 4 is a block diagram showing the structure of an LDPC coding/decoding system;
[Fig. 5] Fig. 5 is a block diagram showing the structure of a check matrix generating apparatus in accordance with embodiment 1 of the present invention;
[Fig. 6] Fig. 6 is a flow chart showing a flow of processing carried out by the check matrix generating apparatus in accordance with embodiment 1 of the present invention;
[Fig. 7] Fig. 7 is a block diagram showing the structure of a check matrix generating apparatus in accordance with embodiment 2 of the present invention;
[Fig. 8] Fig. 8 is a flow chart showing a flow of processing carried out by the check matrix generating apparatus in accordance with embodiment 2 of the present invention;
[Fig. 9] Fig. 9 is a diagram showing bit error rate characteristics and frame error rate characteristics for a signal power to noise power ratio per 1 bit of information; [Fig. 10] Fig. 10 is a block diagram showing the structure of a check matrix generating apparatus in accordance with embodiment 3 of the present invention;
[Fig. 11] Fig. 11 is a flow chart showing a flow of processing carried out by the check matrix generating apparatus in accordance with embodiment 3 of the present invention;
[Fig. 12] Fig. 12 is a block diagram showing the structure of a check matrix generating apparatus in accordance with embodiment 4 of the present invention;
[Fig. 13] Fig. 13 is a flow chart showing a flow of processing carried out by the check matrix generating apparatus in accordance with embodiment 4 of the present invention;
[Fig. 14] Fig. 14 is a diagram showing an example of an ensemble of Multi-edge type;
[Fig. 15] Fig. 15 is a diagram showing an example of an irregular LDPC code;
[Fig. 16] Fig 16 is a diagram showing an example of a checkmatrix which is constructed according to a degree distribution of Fig. 15;
[Fig. 17] Fig. 17 is a diagram showing an example of the degree distribution of the irregular LDPC code which is used for evaluation;
[Fig. 18] Fig. 18 is a diagram showing frame error rate characteristics of the irregular LDPC code;
[Fig. 19] Fig. 19 is a block diagram showing the structure of a check matrix generating apparatus in accordance with embodiment 5 of the present invention; and
[Fig. 20] Fig. 20 is a block diagram showing the structure of a communication apparatus in accordance with embodiment 6 of the present invention.

Preferred Embodiments of the Invention

Hereafter, in order to explain this invention in greater detail, the preferred embodiments of the present invention will be described with reference to the accompanying drawings. The present invention is not limited by the embodiments.

Embodiment 1.

First, before a check matrix generation method for LDPC codes according to this embodiment 1 is explained, the position of an encoder and a decoder which use a generated check matrix for LDPC codes, and a prior art check matrix generation method for "Irregular-LDPC codes" will be explained.

Fig. 4 is a block diagram showing the structure of an LDPC coding/decoding system. As shown in Fig. 4, a communication apparatus on a transmit side of the system includes an encoder 101 and a modulator 102, while a communication apparatus on a receive side of the system includes a demodulator 104 and a decoder 105. Hereafter, a flow of coding and decoding in a case of using a generated check matrix for LDPC codes will be explained.

The communication apparatus on the transmit side of the system uses a check matrix H generated by an LDPC code check matrix generating apparatus, as will mentioned below. The encoder 101 calculates a generator matrix G on the basis of the following conditions:

G: $K \times N$ matrix (K is an information length and N is a code length)

$GH^T=0$ (the superscript T indicates that the matrix is the transpose of the given matrix)

After that, the encoder 101 receives a message ($u_1$ $u_2$ ... $u_k$) having the information length K, and generates a code word C using the above-mentioned generator matrix G.

$$C = (m_1 \ m_2 \ ... \ m_K) \ G$$
$$= (c_1 \ c_2 \ ... \ c_N) \quad (\text{where } H(c_1 \ c_2 \ ... \ c_N)^T = 0)$$

The modulator 102 then performs a digital modulation, such as BPSK, QPSK, or multiple-value QAM, on the generated code word C, and transmits the digital-modulated code word.

However, a problem with this encoder 101 is that because the encoder must generate the generator matrix G from the check matrix H with Gaussian elimination or the like, and the check matrix H has a low density while the generator matrix G has a relatively-high density and the percentage of "1s" included in the binary generator matrix is large, a large amount of memory is needed for storing the generator matrix G.

In order to solve this problem, a technique for incorporating a matrix having a lower triangular structure (or an upper triangular structure) into the check matrix H is proposed by, for example, the following reference:

M. Rashidpour and S.H. Jamali, "Low-Density Parity-Check Codes with Simple Irregular Semi-Random Parity Check Matrix$\times$ for Finite-Length Applications," pp439-443, in proc. IEEE PIMRC 2003.

[Equation 1]

Now, assume that T is an $M \times M$, where $M \in Z_{>0}$, matrix having a lower triangular structure as will shown below. Hereafter, $Z_{>0}$ means a set having all the positive integers.

$$T = \begin{bmatrix} 1 & 0 & 0 & \cdots & 0 \\ 1 & 1 & 0 & \cdots & 0 \\ 0 & 1 & 1 & \cdots & 0 \\ \vdots & \vdots & \ddots & \ddots & \vdots \\ 0 & \cdots & 0 & 1 & 1 \end{bmatrix}$$

A binary $M \times N$, where $M \in Z_{>0}$, matrix $H=[h_{i,j}]$ comprised of an element $h_{i,j}$ in the $i$th row and $j$th column of the matrix can be expressed as follows.

$$H = \begin{bmatrix} A_{M \times A} | T \end{bmatrix}$$

where H is an $M \times N$ matrix, and $A_{M \times A}$ is an arbitrary binary $M \times K$ matrix, where $K=K-M$.

In a case in which a systematic-code word vector $C$ is expressed as $C=(u1, u2, ..., uk, p1, p2, ..., pM)$, this code word vector $C$ satisfies $H \cdot C^T=0$. In a case in which an information message $u=(u_p, u_a, ..., u_k)$ is provided, the encoder 101 generates parity elements according to the following equations:

$$p_1 = \sum_{i=1}^{K} m_i h_{1,M+k}$$

$$p_m = p_{m-1} + \sum_{i=1}^{K} m_i h_{m,M+i} \quad , 2 \le m \le M$$

Because coding can be easily implemented according to this procedure even if the generator matrix G is not used, the present invention is based on the premise that the check matrix H is so constructed as to include a matrix having a lower triangular structure.

On the other hand, the communication apparatus on the receive side of the system receives information about necessary features from the communication apparatus on the transmit side of the system in advance, and generates a check matrix. The demodulator 104 performs a digital demodulation, such as BPSK, QPSK, or multiple-value QAM, on the modulated signal received via a communication path 103, and the decoder 105 performs iteration decoding based on the "sum-product algorithm" on the demodulated result which is LDPC-coded using the generated check matrix, and outputs an estimation result (which corresponds to the original message $u_1 u_2 ... u_K$).

Next, a prior art check-matrix generation method for "Irregular-LDPC codes" which is theoretically analyzed in above-mentioned nonpatent reference 5 will be explained in detail. In accordance with this method, by iterately calculating the probability density function of a log-likelihood ratio (LLR) between the input and output of the decoder 105 according to the decoding process of the sum-product decoding method, a good ensemble of the degrees of rows and the degrees of columns is calculated using a technique which is called a density evolution method of analyzing the decoding characteristics of the sum-product decoding method, and a Gaussian approximation method which is approximate to the density evolution method.

Both the density evolution method described in above-mentioned nonpatent reference 5, which is a check matrix generation method for LDPC codes, and the Gaussian approximation (Gaussian Approximation) method which simplifies calculations by assuming that the log-likelihood ratio (LLR) between the input and output in the decoder 105 can be approximated by a Gaussian distribution are based on the premise that in a check matrix, each column is defined as a variable node and each row is defined as a check node using expressions of a Tanner graph. Furthermore, a case in which "1" is located at a point of intersection of a certain column and a certain row is referred to as a case that the variable node and the check node are connected to each other via an "edge. "

First, transmission of an LLR message from a check node to a variable node will be analyzed. On the following conditions: $0<s<\infty$ and $0<=t<\infty$, the following function (1) is defined. In this function, $s=m_{u0}$ is the mean of u0, u0 is the ensemble mean of the log-likelihood ratio (LLR) of a signal which has been received via a transmission line containing Gauss noise with variance $\sigma_n^2$, and t is the ensemble mean of the LLR output values of the check nodes at a predetermined iteration.

[Equation 2]

$$f_j(s,t) = \phi^{-1}\left(1 - \left[1 - \sum_{i=2}^{d_1} \lambda_i \phi(s + (i-1)t)\right]^{j-1}\right)$$

$$f(s,t) = \sum_{j=2}^{d_r} \rho_j f_j(s,t) \quad \cdots (1)$$

where $\lambda_i$ and $\rho_i$ denote the fractions of edges belonging to degree-i variable and check nodes, respectively, $d_1$ is a

maximum degree of the variable nodes, and $d_r$ is a maximum degree of the check nodes. Above-mentioned $\lambda(x)$ and $\rho(x)$ denote the generating functions of the degree distributions for the variable and check nodes, respectively (the number of "1s" included in each column or each variable node is expressed as the degree of each variable node, and the number "1s" included in each row or each check node is expressed as the degree of each check node), and can be given by the following equations (2) and (3):

[Equation 3]

$$\lambda(x) = \sum_{i=2}^{d_1} \lambda_i x^{i-1} \qquad \cdots(2)$$

$$\rho(x) = \sum_{i=2}^{d_r} \rho_i x^{i-1} \qquad \cdots(3)$$

Furthermore, $\varphi(x)$ in the above-mentioned equation (1) is defined as shown in the following equation (4):

[Equation 4]

$$\phi(x) = \begin{cases} 1 - \dfrac{1}{\sqrt{4\pi x}} \int_R \tanh \dfrac{u}{2} \cdot e^{-\frac{(u-x)^2}{4x}} \, du & \text{if} \quad x > 0 \\ 1 & \text{if} \quad x \leq 0 \end{cases} \qquad \cdots(4)$$

where R denotes a set consisting of all real numbers, and u denotes the ensemble mean of the LLR outputs of the variable nodes.

The above-mentioned equation (1:) can be equivalently given by the following equation (5):

[Equation 5]

$$t_1 = f(s, t_{1-1}) \qquad \cdots(5)$$

where $t_1$ is the ensemble mean of the LLR output values of the check nodes at the *1*th iteration.

A condition for calculating the threshold (threshold) of SNR which can make errors become 0 is the one that $t_1(s)$ converges to infinity (this convergence is expressed as $R^+$) as $1 \to \infty$. In order that this condition is satisfied, a condition given by the following equation (6) needs to be satisfied.

[Equation 6]

$$t < f(s, t), \quad \forall\, t \in R^{+} \quad \cdots (6)$$

Next, transmission of LLR messages from variable nodes to check nodes will be analyzed. On the condition that $0 < s < \infty$ and $0 < r <= l$, the following function given by equation (7) is defined.

[Equation 7]

$$h_i(s, r) = \phi\left( s + (i - 1)\sum_{j=2}^{d_r} \rho_j \phi^{-1}\left(1 - (1 - r)^{j-1}\right) \right)$$

$$h(s, r) = \sum_{i=2}^{d_1} \lambda_i h_i(s, r) \quad \cdots (7)$$

where the initial value $r_0$ of r is $\varphi(s)$.

The above-mentioned equation (7) can be equivalently given by the following equation (8):

[Equation 8]

$$r_1 = h(s, r_{l-1}) \quad \cdots (8)$$

A condition for calculating the threshold (threshold) of SNR which can make errors become 0 is the one that $r_1(s)$ converges to 0. In order that this condition is satisfied, a condition given by the following equation (9) needs to be satisfied.

[Equation 9]

$$r > h(s, r), \quad \forall\, r \in (0, \ \phi(s)) \quad \cdots (9)$$

In accordance with above-mentioned nonpatent reference 5, optimal degrees for the variable and check nodes are searched for using the above-mentioned equations according to the following procedure (i.e., a Gaussian approximation which is approximate to the density evolution method).

[Step ST101]

Assuming that the generating function $\lambda(x)$ of the degree distribution of the variable nodes and the Gauss noise $\sigma_n$ are given, a point where the coding rate is maximized is searched for by setting the generating function $\rho(x)$ of the degree distribution of the check nodes as a variable. The restriction conditions imposed on this search are normalizing of the generating function so that $\rho(1)$ becomes equal to 1, and the satisfaction of the above-mentioned equation (6).

[Step ST102]

Assuming that the generating function p (x) of the degree distribution of the check nodes and the Gauss noise

$\sigma_n$ (e.g., values acquired as a result of performing ST101), a point where the coding rate is maximized is searched for by setting the generating function $\lambda(x)$ of the degree distribution of the variable nodes as a variable. Restrictions on this search are normalizing of the generating function so that $\lambda(1)$ becomes equal to 1, and the satisfaction of the above-mentioned equation (9).

[Step ST103]

In order to calculate the largest coding rate, above-mentioned steps ST101 and ST102 are carried out repeatedly, a better ensemble of the generating function $\lambda(x)$ of the degree distribution of the variable nodes, and the generating function p (x) of the degree distribution of the check nodes is searched for using linear programming.

[Step ST104]

The signal power is normalized to 1 with the Gauss noise $\sigma_n$, and the threshold (threshold) of SNR that can make errors become 0 is calculated using the following equation (10).

[Equation 10]

$$\text{threshold}\,(dB) = -10 * \log 10\left(2 * \sigma_n^2\right) \quad \cdots (10)$$

However, a problem with above-mentioned nonpatent reference 5 is that the check matrix acquired from the maximum of the coding rate becomes fluid, and the coding rate which was fixedly designed to specifications varies. A further problem with above-mentioned nonpatent reference 5 is that because the derivation of the generating function $\lambda(x)$ of the degree distribution of the variable nodes and the derivation of the generating function p (x) of the degree distribution of the check nodes are repeatedly performed a predetermined number of times, it takes a certain amount of time to carry out the search processing and the disclosed method cannot easily respond to various ensembles, various code lengths, and various coding rates.

Therefore, in this embodiment 1, a method of easily searching for a check matrix for "Irregular-LDPC codes" which is deterministic, which have stable characteristics, and which supports various ensembles, various code lengths, and various coding rates in a short time will be explained.

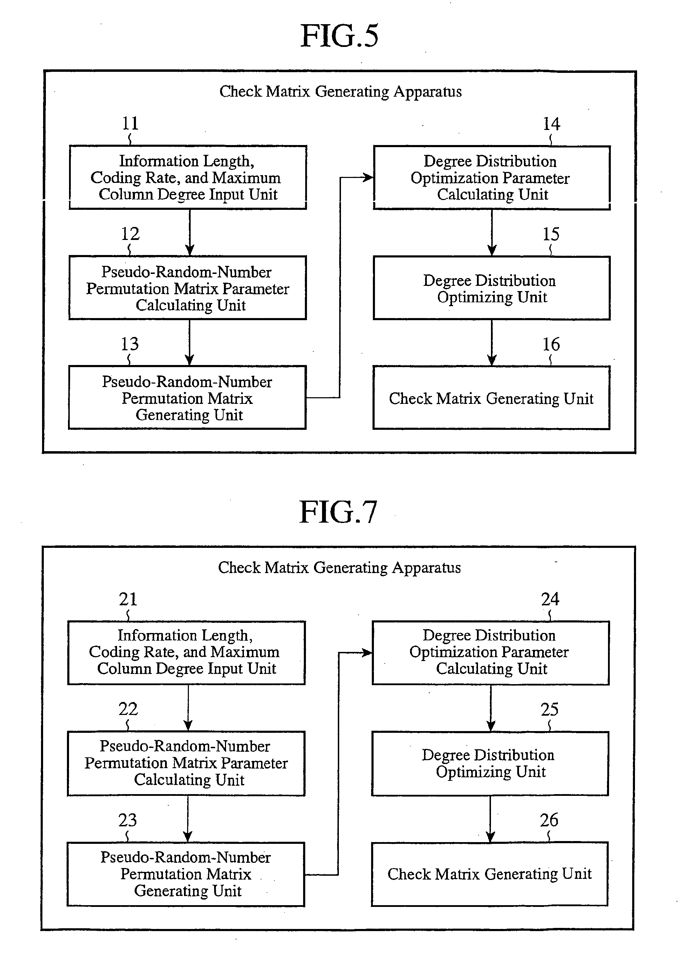

Fig. 5 is a block diagram showing the structure of a check matrix generating apparatus for LDPC codes in accordance with embodiment 1 of the present invention. This check matrix generating apparatus is provided with an information length, coding rate, and maximum column degree input unit 11, a pseudo-random-number permutation matrix parameter calculating unit 12, a pseudo-random-number permutation matrix generating unit 13, a degree distribution optimization parameter calculating unit 14, a degree distribution optimizing unit 15, and a check matrix generating unit 16. This check matrix generating apparatus can be mounted in each of the communication apparatus on the transmit side of the system shown in Fig. 4 and that on the receive side of the system so that they can output generated check matrices to the encoder 101 and decoder 105, respectively. As an alternative, the check matrix generating apparatus can be mounted outside each of the communication apparatus on the transmit side of the system and that on the receive side of the system so that they can store generated check matrices in memories (not shown) in the communication apparatus on the transmit and receive sides of the system and output them to the encoder 101 and decoder 105, respectively.

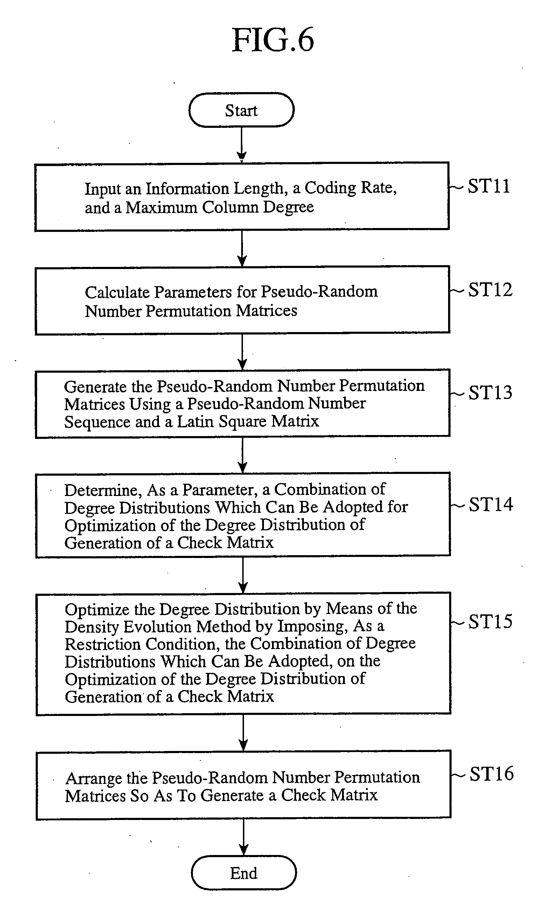

Fig. 6 is a flow chart showing a flow of processing carried out by the check matrix generating apparatus in accordance with embodiment 1 of the present invention. In step ST11, the information length, coding rate, and maximum column degree input unit 11 inputs a predetermined information length, a coding rate, and a maximum column degree. In step ST12, the pseudo-random-number permutation matrix parameter calculating unit 12 calculates a parameter for a pseudo-random-number permutation matrix using the predetermined information length, coding rate, and maximum column degree which are inputted in above-mentioned step ST11.

In step ST13, the pseudo-random-number permutation matrix generating unit 13 generates pseudo-random-number permutation matrices from the parameter for the pseudo-random-number permutation matrix, which is calculated in above-mentioned step ST12, using a pseudo-random-number sequence and a Latin square matrix. In step ST14, using the predetermined information length, coding rate, and maximum column degree which are inputted in above-mentioned step ST11, the degree distribution optimization parameter calculating unit 14 determines, as a parameter, a combination of degree distributions which can be adopted for optimization of the degree distribution of generation of a check matrix which can be constructed using the pseudo-random-number permutation matrices.

In step ST15, the degree distribution optimizing unit 15 optimizes the degree distribution of generation of a check matrix by means of a density evolution method by imposing, as a restriction condition, the combination of the degree distributions which can be adopted, which is determined in above-mentioned step ST14, on the optimization of the degree distribution of generation of the check matrix. In step ST16, according to the degree distribution of generation of a check matrix, which is optimized in above-mentioned step ST15, the check matrix generating unit 16 arranges the pseudo-random-number permutation matrices which are generated in above-mentioned step ST13 so as to generate a check matrix for LDPC codes.

Next, the details of processes in steps ST11 to ST16 in the flow chart of Fig. 6 will be explained. In step ST11, the information length, coding rate, and maximum column degree input unit 11 inputs, as the predetermined information length, coding rate, and maximum column degree, an information length K=144, a coding rate rate=0.5, and a maximum column degree d=4 which are set up in advance in the system.

In step ST12, using the information length K=576, coding rate rate=0.5, and maximum column degree d=4, which are inputted in above-mentioned step ST11, the pseudo-random-number permutation matrix parameter calculating unit 12 calculates a parameter p for a $p^2 \times p^2$ (p+1 is a prime number) pseudo-random-number permutation matrix SP as follows:

The number of pseudo-random-number permutation matrices SPs which are arranged in a direction of rows =d=4
The number of columns of the check matrix H N (= code length N)=K/rate
= 144/0.5=288
The number of rows of the check matrix H M=N×(1-rate)
=288×0.5=144
The size of each pseudo-random-number permutation matrix SP $p^2$=M/d=144/4=36
Therefore p= 6.

In step ST13, the pseudo-random-number permutation matrix generating unit 13 generates the pseudo-random-number permutation matrix SP of order $p^2 \times p^2$ (p+1 is a prime number) from the parameter p for the pseudo-random-number permutation matrix SP calculated in above-mentioned step ST12 using the pseudo-random-number sequence and the Latin square matrix, as shown in the procedure of steps ST13-1 to ST13-6 which will be explained below.

In general, in coding/decoding using an LDPC code, the smaller number of such cycles as "cycle 4" and "cycle 6" in which the check matrix has a small size on a bipartite graph which is a Tanner graph, the better characteristics can be provided.

Therefore, it is desirable that LDPC codes have a structure of suppressing occurrence of such cycles as "cycle 4" and "cycle 6" in which the check matrix has a small size. The pseudo-random-number permutation matrix generating unit 13 therefore generates the pseudo-random-number permutation matrices SPs so that these matrices suppress occurrence of such cycles in which the check matrix has a small size.

[Step ST13-1]

[Equation 11]

Generate a pseudo-random number sequence C(i) defined by the following equation:

$$C(1) = 1, \quad C(i+1) = G_0 \times C(i) \bmod P, \quad i = 1, 2, ..., P - 2,$$

where $P$ is a prime number which is expressed as $P=p+1$, and $G_0$ is a primitive element of $GF(P)$. In a case in which successive powers of $G_0$ which are elements of $GF(P)$ (e.g., $G_0^1$, $G_0^2$, ..., $G_0^{P-1}=1$) are all non-zero elements of $GF(P)$, $G_0$ is called a primitive element. This sequence $C(i)$ is a pseudo-random number sequence in which the difference among its elements is ununiform, and no identical elements exist.

As an example, a case of $P= 7$ and $G_0=3$ will be shown below.

$$
\begin{array}{ccccccc}
i: & 1 & 2 & 3 & 4 & 5 & 6 \\
C(i): & 1 & 3 & 2 & 6 & 4 & 5
\end{array}
$$

[Step ST13-2]

[Equation 12]

A permutation pattern $LB_j(i)$ for the pseudo-random number sequence $C(i)$, which is given by the following equation, is generated.

$$LB_j(i) = (j \times i) \bmod P, \quad j = 1,2,...,p, \quad i = 1,2,...,p.$$

With this operation, when $LB_j(i)$ is expressed by a matrix with $j$ rows and $i$ columns, all elements in each row and all elements in each column can construct different Latin squares.
An example will be shown below.

$$
\begin{array}{llcccccc}
i: & & 1 & 2 & 3 & 4 & 5 & 6 \\
LB_1(i) & & 1 & 2 & 3 & 4 & 5 & 6 \\
LB_2(i) & & 2 & 4 & 6 & 1 & 3 & 5 \\
LB_3(i) & & 3 & 6 & 2 & 5 & 1 & 4 \\
LB_4(i) & & 4 & 1 & 5 & 2 & 6 & 3 \\
LB_5(i) & & 5 & 3 & 1 & 6 & 4 & 2 \\
LB_6(i) & & 6 & 5 & 4 & 3 & 2 & 1 \\
\end{array}
$$

[Step ST13-3]

[Equation 13]

According to the following equation, a Latin square matrix $L_j(q, l)$ having, as elements, a pseudo-random number sequence and a permutation pattern of the sequence is generated.

$$L_j(q, LB_j(((q+i-2)\bmod p)+1)) = C(i),$$
$$j = 1,2,...,p, \quad i = 1,2,...,p, \quad q = 1,2,..,p.$$

With this operation, p different Latin square matrices $L_1(q, 1)$, $L_2(q, 1)$, ..., $Lp(q, l)$ can be generated using $L_j(q, l)$.
An example will be shown below.

$$
\begin{array}{lcccccc}
l: & 1 & 2 & 3 & 4 & 5 & 6 \\
L_1(1,l) & 1 & 3 & 2 & 6 & 4 & 5 \\
L_1(2,l) & 3 & 2 & 6 & 4 & 5 & 1 \\
\vdots & \vdots & \vdots & \vdots & \vdots & \vdots & \vdots \\
L_1(6,l) & 5 & 1 & 3 & 2 & 6 & 4 \\
L_2(1,l) & 6 & 1 & 4 & 3 & 5 & 2 \\
L_2(2,l) & 1 & 4 & 3 & 5 & 2 & 6 \\
\vdots & \vdots & \vdots & \vdots & \vdots & \vdots & \vdots \\
L_2(6,l) & 2 & 6 & 1 & 4 & 3 & 5 \\
\vdots & \vdots & \vdots & \vdots & \vdots & \vdots & \vdots \\
L_6(1,l) & 5 & 4 & 6 & 2 & 3 & 1 \\
L_6(2,i) & 4 & 6 & 2 & 3 & 1 & 5 \\
\vdots & \vdots & \vdots & \vdots & \vdots & \vdots & \vdots \\
L_6(6,l) & 1 & 5 & 4 & 6 & 2 & 3 \\
\end{array}
$$

[Equation 14]

As can be seen from this example, it can be understood that when each element of $L_j(q= 1, 1)$ is arranged for $q= 1$, as will be shown below, all elements in each row and all elements in each column are different Latin square matrices.

$$
\begin{array}{lcccccc}
i: & 1 & 2 & 3 & 4 & 5 & 6 \\
L_1(1,i) & 1 & 3 & 2 & 6 & 4 & 5 \\
L_2(1,i) & 6 & 1 & 4 & 3 & 5 & 2 \\
L_3(1,i) & 4 & 2 & 1 & 5 & 6 & 3 \\
L_4(1,i) & 3 & 6 & 5 & 1 & 2 & 4 \\
L_5(1,i) & 2 & 5 & 3 & 4 & 1 & 6 \\
L_6(1,i) & 5 & 4 & 6 & 2 & 3 & 1 \\
\end{array}
$$

Similarly, a matrix with $j$ rows and $l$ columns in which each element of $L_j(q, l)$ is arranged for each of $q= 2, ..., p$ is also a Latin square.

[Step ST13-4]

[Equation 15]

According to the following equation, a fundamental permutation matrix pattern $BP_j(q, 1)$ is generated using the Latin square matrix $L_j(q, l)$ and a parameter $p$.

$$
BP_j(q,i) = L_j(q,i) + p \times (i-1),
$$
$$
j = 1,2,..., p, \quad i = 1,2,..., p, \quad q = 1,2,.., p.
$$

With this operation, the fundamental permutation matrix pattern for generating $p^2 \times p^2$ pseudo random number permutation matrices with column degree 1 and row degree 1 can be generated.

$BP_j(q, i)$ is a matrix in which when a matrix with $q$ rows and $i$ columns is generated for the certain $j$ of $L_j(q, i)$, $p$ is added to each element in each row of the matrix every time the number of each row is incremented by 1.

An example will be shown below.

[Equation 16]

$$
\begin{array}{lcccccc}
i: & 1 & 2 & 3 & 4 & 5 & 6 \\
BP_4(1,i) & 3 & 6 & 5 & 1 & 2 & 4 \\
BP_4(2,i) & 12 & 11 & 7 & 8 & 10 & 9 \\
BP_4(3,i) & 17 & 13 & 14 & 16 & 15 & 18 \\
BP_4(4,i) & 19 & 20 & 22 & 21 & 24 & 23 \\
BP_4(5,i) & 26 & 28 & 27 & 30 & 29 & 25 \\
BP_4(6,i) & 34 & 33 & 36 & 35 & 31 & 32
\end{array}
$$

As can be seen from the discussion in the previous step (3), a matrix with $j$ rows and $l$ columns in which elements of $BP_j$ $(q, l)$ for the certain $q$ are arranged is also a Latin square. Furthermore, with this operation, the distance between elements in the same column of a matrix with $q$ rows and $l$ columns which is generated from $BP_j(q, l)$ for the certain $j$ is increased.

[Step ST13-5]

[Equation 17]

According to the following equation, a plurality of fundamental permutation sequences $SP_{j,s}(i)$ in each of which the starting point of the fundamental permutation matrix pattern $BP_j(q, l)$ is shifted by s are generated.

$$
SP_{j,s}(i) = BP_j(((i+s-2)\bmod p)+1, \lceil i/p \rceil),
$$
$$
j = 1,2,...,p, \quad i = 1,2,...,p^2, \quad s = 1,2,..,p.
$$

With this operation, the plurality of fundamental permutation sequences for generating $p^2 \times p^2$ pseudo random number permutation matrices with column degree 1 and row degree 1 can be generated.

The distance between any adjacent elements in each of the plurality of sequences is increased. By increasing the distance between any adjacent elements, occurrence of the short cycles, i . e . , cycle 4 and cycle 6, which can occur in the lower triangular matrix of T previously explained in embodiment 1 can be prevented.

An example will be shown below.

[Equation 18]

$$
\begin{array}{ccccccc}
i: & 1 & 2 & 3 & 4 & 5 & 6 \\
SP_{4,3}(i) & 17 & 19 & 26 & 34 & 3 & 18
\end{array}
$$

$$
\begin{array}{ccccccc}
i: & 7 & 8 & 9 & 10 & 11 & 12 \\
SP_{4,3}(i) & 13 & 20 & 28 & 33 & 6 & 11
\end{array}
$$

$$
\begin{array}{ccccccc}
i: & 13 & 14 & 15 & 16 & 17 & 18 \\
SP_{4,3}(i) & 14 & 22 & 27 & 36 & 5 & 7
\end{array}
$$

$$
\begin{array}{ccccccc}
i: & 19 & 20 & 21 & 22 & 23 & 24 \\
SP_{4,3}(i) & 16 & 21 & 30 & 35 & 1 & 8
\end{array}
$$

$$
\begin{array}{ccccccc}
i: & 25 & 26 & 27 & 28 & 29 & 30 \\
SP_{4,3}(i) & 15 & 24 & 29 & 31 & 2 & 10
\end{array}
$$

$$
\begin{array}{ccccccc}
i: & 31 & 32 & 33 & 34 & 35 & 36 \\
SP_{4,3}(i) & 18 & 23 & 25 & 32 & 4 & 9
\end{array}
$$

[Step ST13-6]

[Equation 19]

From the plurality of fundamental permutation sequences $SP_{j,s}(i)$, $p^2 \times p^2$ binary pseudo random number permutation matrices $SP_{j,s}=(h_{m,n})$, which are defined by the following equation, are generated.

$$
h_{m,n} := \begin{cases} 1, & \text{if } n = SP_{j,s}(m) \\ 0, & \text{otherwise} \end{cases}
$$

With this operation, the plurality of $p^2 \times p^2$ pseudo random number permutation matrices with column degree 1 and row degree 1 can be generated. In a matrix which consists of a combination of a plurality of $SP_{j,s}$ with identical s and different j, because the number of any column in which "1" exists in each row does not match with that of any column in which "1" exists in any other row, cycle 4 does not exist and the minimum number of cycles is 6. Furthermore, there can be a combination of a plurality of $SP_{j,s}$ with different s for which cycle 4 does not exist, and this combination can be obtained through search or the like.
An example will be shown below.

$$
SP_{4,3} = \begin{bmatrix} 0 & 0 & 0 & 0 & 0 & 0 & 0 & 0 & 0 & 0 & 0 & 0 & 0 & 0 & 0 & 0 & 1 & 0 & 0 & \cdots \\ 0 & 0 & 0 & 0 & 0 & 0 & 0 & 0 & 0 & 0 & 0 & 0 & 0 & 0 & 0 & 0 & 0 & 0 & 1 & \cdots \\ \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots \\ 0 & 0 & 0 & 1 & 0 & 0 & 0 & 0 & 0 & 0 & 0 & 0 & 0 & 0 & 0 & 0 & 0 & 0 & 0 & \cdots \\ 0 & 0 & 0 & 0 & 0 & 0 & 0 & 0 & 1 & 0 & 0 & 0 & 0 & 0 & 0 & 0 & 0 & 0 & 0 & \cdots \end{bmatrix}
$$

In step ST14, using the predetermined information length K, coding rate rate, and maximum column degree d which are inputted in above-mentioned step ST11, the degree distribution optimization parameter calculating unit 14 determines, as a parameter, a combination of degree distributions which can be adopted for optimization of the degree distribution of generation of a check matrix which can be constructed using the pseudo-random-number permutation matrices. In this case, the degree distribution optimization parameter calculating unit determines a combination of degree distributions which can be adopted in consideration of the maximum column degree d and under the restriction condition imposed on the check matrix containing a lower triangular matrix.

The restriction condition imposed on the check matrix H as given by the following equation is determined from the target maximum column degree d, information length K, and coding rate rate.

[Equation 20]

$$H = d \cdot p^2 \left\{ \begin{bmatrix} SP & SP & \cdots & SP & \diagdown & \mathbf{0} & \cdots & \mathbf{0} \\ SP & SP & \cdots & SP & SP & \diagdown & \ddots & \vdots \\ \vdots & \vdots & \vdots & \vdots & \vdots & \ddots & \diagdown & \mathbf{0} \\ SP & \cdots & \cdots & \cdots & \cdots & SP & SP & \diagdown \end{bmatrix} \right.$$

Here, $SP$ shows an arbitrary $SP_{j,s}$. Furthermore, a series of \ arranged on a diagonal line shows that 1s are arranged in the shape of stairs from the top row to the bottom row in the matrix H, as in the case of **T.**

The restriction condition which is determined at that time includes the size of each pseudo-random-number permutation matrix SP, a maximum number of pseudo-random-number permutation matrices which are to be arranged, and the positions where the pseudo-random-number permutation matrices are to be arranged.

As an example, a case in which the information length K=144, the coding rate rate=0.5, and the maximum column degree d=4 will be shown below.

The number of pseudo-random-number permutation matrices SPS whic are arranged in a direction of rows =d=4

The number of columns of the check matrix H N (=code length N) =K/rate

=144/0.5=288

The number of rows of the check matrix N M=N×(1-rate)

=288×0.5=144

The size of each pseudo-random-number permutation matrix $p^2$=M/d=144/4=36

Therefore p= 6

The maximum number of the pseudo-random-number permutation matrices SPs which are arranged in the information length portion =N×rate/$p^2$=288×0.5/36=4

It can be seen from these results that in the check matrix H, (4x4) pseudo-random-number permutation matrices SPs can be arranged in a left end portion, and (3+2+1) pseudo-random-number permutation matrices SPs can be arranged in a lower left triangular portion on a right-hand side of the check matrix.

The degree distribution optimization parameter calculating unit determines a combination of degree distributions which can be adopted in consideration of the maximum column degree and under the restriction condition imposed on the check matrix containing a lower triangular matrix. A degree distribution shows, for example, the percentage of the number of columns corresponding to column degree 4 in the number of columns of the whole check matrix, and the degree distribution optimization parameter calculating unit generates a combination of four pseudo-random-number permutation matrices (with column weight 1 and row weight 1) in the direction of columns according to the percentage so that they have a column degree 4. The degree distribution optimization parameter calculating unit similarly generates a combination of four pseudo-random-number permutation matrices for row degree. For example, in the above-mentioned example, for the number of columns of the whole check matrix H with column weight 4, the fraction which can be adopted using the pseudo-random-number permutation matrices ranges from 0 to 4/8, and for the number of columns of the whole check matrix H with column weight 3, the fraction which can be adopted using the pseudo-random-number permutation matrices ranges from 0 to 5/8. The combination of these column and row degrees and the fraction which can be adopted are outputted as parameters for the optimization of the degree distribution which is to be carried out in the following step ST15.

In step ST15, the degree distribution optimizing unit 15 optimizes the degree distribution of generation of a check matrix using the density evolution method according to, as a restriction condition, the combination of degree distributions which can be adopted, which is determined in the above-mentioned step ST14, as will be mentioned below. In this case, the degree distribution optimizing unit determines an optimal degree distribution from among the combination of degree distributions determined in above-mentioned step ST14. A degree distribution shows, for example, the percentage of the number of columns corresponding to column degree 4 in the number of columns of the whole check matrix, and the degree distribution optimization parameter calculating unit generates a combination of four pseudo-random-number permutation matrices (with column weight 1 and row weight 1) in the direction of columns according to the percentage so that they have a column degree 4. Thus, the degree distribution optimization parameter calculating unit, in next step ST16, can generate a check matrix.

According to the restriction condition including the size of each pseudo-random-number permutation matrix SP, the maximum number of the pseudo-random-number permutation matrices which can be arranged, and the positions where the pseudo-random-number permutation matrices can be arranged in the check matrix H, which are determined in above-mentioned step ST14, the degree distribution optimization parameter calculating unit, in step ST15, arranges arbitrary pseudo-random-number permutation matrices SPs at positions where the pseudo-random-number permutation matrices SPs can be arranged in the check matrix H, or selects a combination of pseudo-random-number permutation matrices on the condition that $p^2 \times p^2$ all-zero matrices are arranged at the positions.

Next, the degree distribution optimization parameter calculating unit calculates an ensemble (degree distribution) of "Irregular-LDPC codes" based on a requested coding rate using an optimization method which is based on a Gaussian approximation method which is approximate to the density evolution method.

The degree distribution optimization parameter calculating unit then treats, as variables, the generating function $\lambda(x)$ of the degree distribution for the columns and the generating function $\rho(x)$ of the degree distribution for the rows simultaneously, and searches for an optimal generating function $\lambda(x)$ and an optimal generating function $\rho(x)$ with linear programming so that the Gauss noise $\sigma_n$ can become its maximum (see the following equation (11)). A restriction condition imposed on this search is the satisfaction of an equation (12) which will be mentioned below.

At this time, assume that values which the generating function $\lambda(x)$ of the degree distribution for the columns and the generating function $\rho(x)$ of the degree distribution for the rows, which are the variables, can have are only values which are calculated under the restriction condition imposed on the above-mentioned check matrix H.

[Equation 21]

$$h_i(s,r) = \phi\left(s + (i-1)\sum_{j=2}^{\mu_{max}} \rho j \phi\left(1 - (1-r)^{j-1}\right)\right)$$

$$h(s,r) = \sum_{i=2}^{\gamma_{max}} \lambda_i h_i(s,r) \qquad \cdots(11)$$

$$\phi(x) = \begin{cases} 1 - \dfrac{1}{\sqrt{4\pi x}}\int_R \tanh\dfrac{\mu}{2}\cdot e^{-\frac{(\mu-x)}{4x}}d\mu, & \text{if } x > 0 \\ 1, & \text{if } x \le 0 \end{cases}$$

$$\frac{\int_0^1 \rho(x)}{\int_0^1 \lambda(x)} = 1 - \text{rate}$$

$$\lambda(1) = 1, \rho(1) = 1 \qquad \cdots(12)$$

$$r > h(s,r), \ \forall \ r \in (0, \ \phi(s))$$

The above-mentioned s is the mean of the log-likelihood ratio (LLR) in a case in which a binary signal of {-1, 1} outputted as a transmit signal is received by way of a Gauss communication path, and can be computed from $s=2/\sigma_n^2$.

Thus, because the generating functions $\lambda(x)$ and $\rho(x)$ which satisfy the predetermined conditions can be calculated through one-time use of linear programming, an ensemble which is deterministic and which has stable characteristics can be generated more easily in a short time as compared with a case of using a prior art method, as disclosed by nonpatent reference 5, of repeatedly carrying out derivation of the generating function $\lambda(x)$ and calculation of the generating function $\rho(x)$ so as to calculate optimum values of both of them.

In step ST16, the check matrix generating unit 16 arranges the pseudo-random-number permutation matrices SPs which are generated in above-mentioned step ST13 on the basis of the degree distribution of generation of a check matrix which is optimized in above-mentioned step ST15, as will be explained below, and generates a check matrix for LDPC codes. That is, the check matrix generating unit determines the arrangement of the pseudo-random-number permutation matrices SP in the check matrix H on the basis of the degree distributions calculated in above-mentioned step ST15.

[Equation 22]

$$H = \begin{bmatrix} SP_{1,1} & SP_{1,2} & SP_{1,4} & SP_{1,7} & \searcharrow & 0 & 0 & 0 \\ SP_{4,3} & SP_{4,6} & SP_{4,10} & SP_{4,1} & 0 & \searcharrow & 0 & 0 \\ SP_{6,8} & SP_{6,12} & SP_{6,16} & SP_{6,13} & 0 & 0 & \searcharrow & 0 \\ SP_{8,14} & SP_{8,5} & 0 & 0 & 0 & 0 & 0 & \searcharrow \end{bmatrix}$$

When determining the arrangement of SPs and parameters for them, a combination of *SP*s without occurrence of short cycles, such as cycle 4 and cycle 6, is determined by adjusting and searching for j and s of $SP_{j,s}$. By changing *j* and *s*, $SP_{j,s}$ becomes a different pseudo random number permutation matrix, and, in a combination of such *SP*s, it is essentially difficult for occurrence of cycles 4 and 6 to take place. Therefore, this method is characterized by that the derivation of a combination of *SP*s can be carried out relatively-easily through search.

As mentioned above, according to this embodiment 1, a check matrix for "Irregular-LDPC codes" which is deterministic, which has stable characteristics, which has a good error correction capability, and which supports various ensembles, various code lengths, and various coding rates can be easily generated in a short time.

Embodiment 2.

Next, a method of generating a check matrix for RC (Rate compatible)-LDPC codes, which is an extension to the method according to embodiment 1 and which is compatible at two or more coding rates (the information length does not vary, but only the coding rate varies).

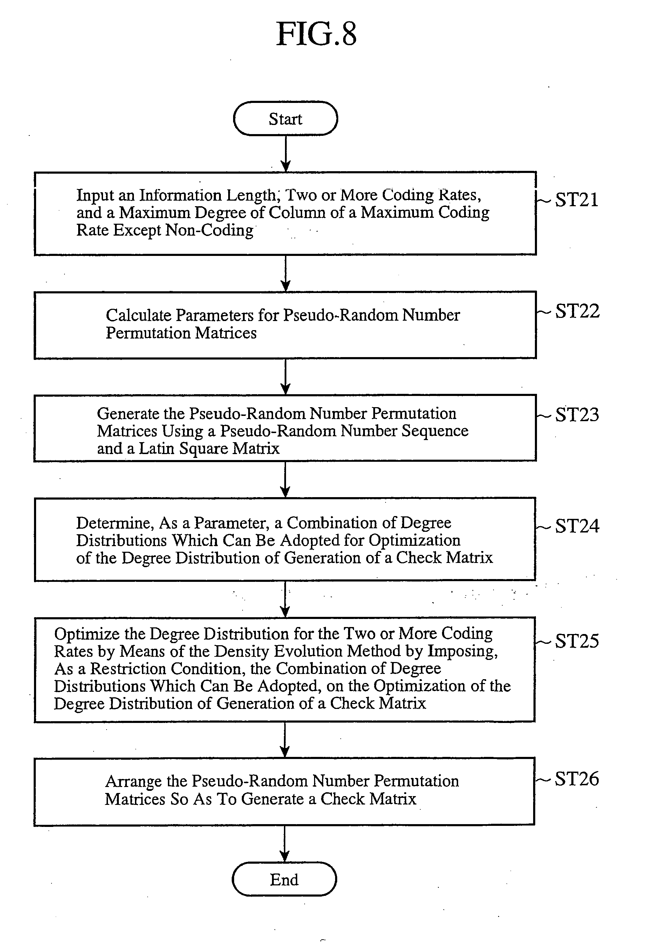

Fig. 7 is a block diagram showing the structure of a check matrix generating apparatus for LDPC codes in accordance with embodiment 2 of the present invention. This check matrix generating apparatus is provided with an information length, coding rate and maximum column degree input unit 21, a pseudo-random-number permutation matrix parameter calculating unit 22, a pseudo-random-number permutation matrix generating unit 23, a degree distribution optimization parameter calculating unit 24, a degree distribution optimizing unit 25, and a check matrix generating unit 26. This check matrix generating apparatus can be mounted in each of the communication apparatus on the transmit side of the system shown in Fig. 4 and that on the receive side of the system so that they can output generated check matrices to the encoder 101 and decoder 105, respectively. As an alternative, the check matrix generating apparatus can be mounted outside each of the communication apparatus on the transmit side of the system and that on the receive side of the system so that they can store generated check matrices in memories (not shown) in the communication apparatus on the transmit and receive sides of the system and output them to the encoder 101 and decoder 105, respectively.

Fig. 8 is a flow chart showing a flow of processing carried out by the check matrix generating apparatus in accordance with embodiment 2 of the present invention. In step ST21, the information length, coding rate, and maximum column degree input unit 21 inputs a predetermined information length, two or more coding rates, and a maximum column degree of a maximum coding rate except non-coding. In step ST22, the pseudo-random-number permutation matrix parameter calculating unit 22 calculates a parameter for pseudo-random-number permutation matrices using the predetermined information length, two or more coding rates, and maximum column degree of the maximum coding rate except non-coding which are inputted in above-mentioned step ST21.

In step ST23, the pseudo-random-number permutation matrix generating unit 23 generates pseudo-random-number permutation matrices from the parameter for the pseudo-random-number permutation matrices, which are calculated in above-mentioned step ST22, using a pseudo-random-number sequence and a Latin square matrix. In step ST24, using the predetermined information length, two or more coding rates, and maximum column degree of a maximum coding rate except non-coding, which are inputted in above-mentioned step ST21, the degree distribution optimization parameter calculating unit 24 determines, as a parameter, a combination of degree distributions which can be adopted for optimization of the degree distribution of generation of a check matrix which can be constructed using the pseudo-random-number permutation matrices.

In step ST25, the degree distribution optimizing unit 25 optimizes the degree distribution of generation of a check matrix by means of a density evolution method by imposing, as a restriction condition, the combination of the degree distributions which can be adopted, which is determined in above-mentioned step ST24, on the optimization of the degree distribution of generation of the check matrix. In step ST26, according to the degree distribution of generation of a check matrix, which is optimized in above-mentioned step ST25, the check matrix generating unit 26 arranges the pseudo-random-number permutation matrices generated in above-mentioned step ST23 so as to generate a check matrix for LDPC codes.

Next, the details of processes in steps ST21 to ST26 in the flow chart of Fig. 8 will be explained.

In step ST21, the information length, coding rate, and maximum column degree input unit 21 inputs the predetermined information length K, two or more coding rates R(1) , and maximum column degree of the maximum coding rate except non-coding. In this case, in the two or more coding rates R(1), 1= 1, 2, ..., and $0<R(1)<R(2)<...<1$. This step ST21 differs from step ST11 of embodiment 1 in that the two or more coding rates R(1) and maximum column degree d of the maximum coding rate except non-coding are inputted.

Hereafter, the number of rows of a check matrix $H_{R(max-1)}$ for the maximum coding rate R(max-1) among the inputted two or more coding rates R(1) is expressed as b, and the number of columns of the check matrix = the code length is expressed as N. In this case, R(max) =1 means the non-coding and will be not used in this explanation.

In step ST22, the pseudo-random-number permutation matrix parameter calculating unit 22 calculates a parameter for the pseudo-random-number permutation matrices using the predetermined information length, two or more coding rates, and maximum column degree of the maximum coding rate except non-coding, which are inputted in above-mentioned step ST21, as will be explained below.

The number of columns of check matrix H N (= code length N)=K/R(1)

The number of rows of check matrix H M=N-K

Next, the size $p^2$ of each pseudo-random-number permutation matrix is calculated from the maximum column degree d (value set up in advance by the system) of the maximum coding rate R(max-1) according to the following equation:

$$p^2=M/d$$

For example, if K=864, R(max-1)=R(3)=2/3, and d=3,

$$N=K/R(3)=864/(2/3)=1,296$$

$$M=N-K=1,296-864=432$$

$$p^2=M/d=432/3=144$$

Therefore p=12.

In step ST23, the pseudo-random-number permutation matrix generating unit 23 carries out the same process as that of step ST13 which the pseudo-random-number permutation matrix generating unit 13 of embodiment 1 carries out. That is, the pseudo-random-number permutation matrix generating unit 23 carries out processes of steps ST13-1 to ST13-6.

In step ST24, using the predetermined information length, two or more coding rates, and maximum column degree of the maximum coding rate except non-coding, which are inputted in above-mentioned step ST21, the degree distribution optimization parameter calculating unit 24 determines, as a parameter, a combination of degree distributions which can be adopted for optimization of the degree distribution of generation of a check matrix which can be constructed using the pseudo-random-number permutation matrices, as will be explained below.

For example, assume that the pseudo-random-number permutation matrix parameter calculating unit inputs the information length K=864, two or more coding rates R(1)=1/3, R(2)=1/2, and R(3)=2/3, and maximum column degree d=3 of the maximum coding rate R(3) except non-coding in above-mentioned step ST21. Furthermore, when the number of rows and the number of columns of a check matrix corresponding to the highest coding rate R(3)=2 among the two or more coding rates R(1) are expressed as $M_3$ and $N_3$, respectively, $M_3=M$ and $N_3=N$ are established and p=12 is derived in step ST22. Furthermore, by expressing the number of rows and the number of columns of a check matrix corresponding to the coding rate R(2)=1/2 as M$_2$ and N$_2$, respectively, and assuming that the information length K does not vary, they are given by the following equations, respectively:

```
The number of columns N₂=K/R(2)=864/(1/2)=1728
```

```
The number of rows M₂=N₂×(1-R(2))=1,728×(1/2)=864
```

Similarly, by expressing the number of rows and the number of columns of a check matrix corresponding to the coding rate R(1) =1/3 as M$_1$ and N$_1$, respectively, and assuming that the information length K does not vary, they are given by the following equations, respectively:

```
The number of columns N₁=K/R(1)=864/(1/3)=2592
```

```
The number of rows M₁=N₁×(1-R(1))=2592×(2/3)=1,728
```

For the number of rows M$_1$=1,728, twelve p$^2$×p$^2$=144×144 pseudo-random-number permutation matrices SPs can be arranged in the direction of rows, and it is clear from K=8 64 that twelve pseudo-random-number permutation matrices SPs can be arranged in the information length portion in the direction of columns. It is clear from these results that in the check matrix H for implementing the coding rate R(1), (12×6) p$^2$×p$^2$=144×144 pseudo-random-number permutation matrices SPs can be arranged in a left end portion, and (11+10+...+1) pseudo-random-number permutation matrices SPs can be arranged in a lower left triangular portion on a right-hand side of the check matrix. R(2) and R(3) can be also formed of this check matrix using a method which will be explained in the following step ST25.

In step ST25, the degree distribution optimizing unit 25 optimizes the degree distribution of generation of a check matrix by means of a density evolution method by imposing, as a restriction condition, the combination of the degree distributions which can be adopted, which is determined in above-mentioned step ST24, on the optimization of the degree distribution of generation of the check matrix, as will be explained below.

$\mathbf{F_2}$={0, 1} is a binary finite field. A code word $\mathbf{C} \subset \mathbf{F_2}^N$, and $\mathbf{H}$= ($h_{ij}$) is an MxN parity check matrix corresponding to $\mathbf{C}$. The code word C consists of a sequence $\mathbf{x}$ having a length of N bits which satisfies M binary parity check bits which are defined by a parity check expression of a parity check matrix $\mathbf{H}x$=0. Assuming that the matrix $\mathbf{H}$ is in a full rank, the number of information bits is expressed as *K=N-M,* and the coding rate is expressed as *R=K/N.*

[Equation 24]

Furthermore, $\mathbf{H}_{R(j)}$ is a parity check matrix for LDPC codes C$_{R(1)}$ whose coding rate is variable. In this case, *R (1)* is the coding rate, where *R(1)*, 1=1, 2, ..., max, and 0<R(1)<R(2)< ...<*R*(max) =1 (*R*(max)=1 means non-coding). Furthermore, $\mathbf{H}_{R(max-1)}$ is an *M×N* parity check matrix for C$_{R(max-1)}$, and $\mathbf{H}_{R(max-2)}$ is an (M+t) ×(N+t) parity check matrix which consists of $\mathbf{H}_{R(max-1)}$, an M×l zero matrix, and a *t×*(*N+t*) additional parity check matrix $\mathbf{A}_{R(max-2)}$, and which is defined by the following equation:

$$H_{R(max-2)} = \left[ \frac{H_{R(max-1)} | 0}{A_{R(max-2)}} \right]$$

($\mathbf{H}_{R(max-1)}$ and $\mathbf{H}_{R(max-2)}$ are both in a full rank.)

$$R(max-1) = \frac{N-M}{N} , \quad R(max-2) = \frac{N-M}{N+t}$$

This process can be expressed by a diagram as follows.

[Equation 25]

This process can be generalized as follows.

[Equation 26]

$$\mathbf{H}_{R(l)} = \left[ \begin{array}{c|c} \mathbf{H}_{R(l+1)} & 0 \\ \hline \mathbf{A}_{R(l)} \end{array} \right]$$

($\mathbf{H}_{R(1)}$s are all in a full rank.)

$$R_{(1)} = (N-M) / (N - \sum_{i=1}^{max-1} ti)$$

Here, $t_i$ shows the difference between the number of columns of $\mathbf{H}_{R(i)}$ and the number of rows of $\mathbf{H}_{R(i+1)}$.
For the design of $\mathbf{H}_{R(i)}$, by means of a Gaussian approximation method which is approximate to the density developing method, the degree distributions of all $\mathbf{H}_{R(i)}$s, 1=1,2,...,max-1 are optimized simultaneously. An optimization problem will be shown below.

[Equation 27]

Here, the degree distribution of $\mathbf{H}_{R(i)}$ which minimizes max $A \sum_{l=1}^{max} GAP_{R(l)}$ is determined.

Here, $GAP_{R(1)}$ denotes the difference between the iteration threshold SNR of $\mathbf{H}_{R(i)}$ which is estimated by means of the Gaussian approximation method and the Shannon limit, which is expressed in dB, and is expressed by the following equation:

$$GAP_{R(l)} = SNR_{R(l)}^{Shannon} - \frac{E}{2\sigma_{n,R(l)}^2} = SNR_{R(l)}^{Shannon} - \frac{1}{2\sigma_{n,R(l)}^2} = SNR_{R(l)}^{Shannon} - \frac{1}{2\sigma_{n,R(l)}^2}$$

$$= SNR_{R(l)}^{Shannon} - \frac{s_{R(l)}}{4}$$

where $SNR_{R(l)}^{Shannon}$, $\sigma_{n,R(l)}^2$ and $s_{R(l)}$ are the Shannon limit of SNR, the variance of noise in the Gauss communication path, the mean of the log-likelihood ratio (LLR) of the signal which is received by way of the Gauss communication path and the energy of the signal in the case of the coding rate $R(1)$, respectively.

Using $GAP_{R(1)}$ and equation (14), the following equation is calculated under the conditions defined by equation (18) for each of the coding rates.

$$\lambda_{R(l)}(x), \rho_{R(l)}(x) = \arg\min_{s_{R(l)}}\left[\sum_{l=1}^{max}(SNR_{R(l)}^{Shannon} - \frac{s_{R(l)}}{4})\right], l = 1,..., max$$

A correspondence between R(1)=1-$M_1$/$N_1$=1/3, R(2)=1-$M_2$/$N_2$=1/2, and R(3)=1-$M_3$/$N_3$=2/3, which are used in above-mentioned step ST24, and the variables used for explanation is given by the following equations:

$$M_3=M, \quad N_3=N, \quad M_2=M_3+t, \quad N_2=N3+t,$$

$$M_1=M_2+t, \quad N_1=N_2+t$$

In step ST26, according to the degree distributions of generation of a check matrix for each of the two or more coding rates, which are optimized in above-mentioned step ST25, the check matrix generating unit 26 arranges the pseudo-random-number permutation matrices generated in above-mentioned step ST23 so as to generate a check matrix for LDPC codes as will be shown below.

For example, for R(1)=1-$M_1$/$N_1$=1/3, R(2)-1-$M_2$/$N_2$=1/2, and R(3)=1-$M_3$/$N_3$=2/3, according to the degree distributions calculated in above-mentioned step ST25, the check matrix generating unit generates a check matrix as will be shown below.

[Equation 28]

$$H = M\begin{cases} M \\ M \\ M \end{cases}\begin{bmatrix} SP_{1,1} & SP_{1,2} & SP_{1,4} & SP_{1,7} & SP_{1,11} & SP_{1,13} & \diagdown & 0 & 0 & 0 & 0 & 0 & 0 & 0 & 0 & 0 & 0 & 0 \\ SP_{4,3} & SP_{4,6} & SP_{4,10} & SP_{4,1} & SP_{4,9} & SP_{4,5} & 0 & \diagdown & 0 & 0 & 0 & 0 & 0 & 0 & 0 & 0 & 0 \\ SP_{6,8} & SP_{6,12} & SP_{6,16} & SP_{6,13} & SP_{6,2} & 0 & 0 & 0 & \diagdown & 0 & 0 & 0 & 0 & 0 & 0 & 0 & 0 \\ SP_{8,14} & SP_{8,5} & 0 & 0 & 0 & 0 & 0 & 0 & 0 & \diagdown & 0 & 0 & 0 & 0 & 0 & 0 & 0 \\ 0 & 0 & SP_{8,8} & SP_{8,16} & 0 & 0 & 0 & 0 & 0 & 0 & \diagdown & 0 & 0 & 0 & 0 & 0 & 0 \\ 0 & 0 & 0 & 0 & SP_{8,7} & 0 & 0 & 0 & 0 & 0 & 0 & \diagdown & 0 & 0 & 0 & 0 & 0 \\ SP_{10,4} & SP_{10,15} & 0 & 0 & 0 & 0 & 0 & 0 & 0 & 0 & 0 & 0 & \diagdown & 0 & 0 & 0 & 0 \\ SP_{12,11} & SP_{12,6} & 0 & 0 & 0 & 0 & 0 & 0 & 0 & 0 & 0 & 0 & 0 & \diagdown & 0 & 0 & 0 \\ 0 & 0 & SP_{10,2} & SP_{10,6} & 0 & 0 & 0 & 0 & 0 & 0 & 0 & 0 & 0 & 0 & \diagdown & 0 & 0 \\ 0 & 0 & SP_{12,9} & SP_{12,16} & 0 & 0 & 0 & 0 & 0 & 0 & 0 & 0 & 0 & 0 & 0 & \diagdown & 0 \\ 0 & 0 & 0 & 0 & 0 & SP_{10,9} & SP_{10,3} & 0 & 0 & 0 & 0 & 0 & 0 & 0 & 0 & 0 & \diagdown & 0 \\ 0 & 0 & 0 & 0 & 0 & 0 & 0 & SP_{12,7} & SP_{12,13} & 0 & 0 & 0 & 0 & 0 & 0 & 0 & 0 & \diagdown \end{bmatrix}$$

with brackets $N_3$, $N_2$, $N_1$ marking column groupings.

Next, the characteristics of LDPC codes as explained above will be compared.

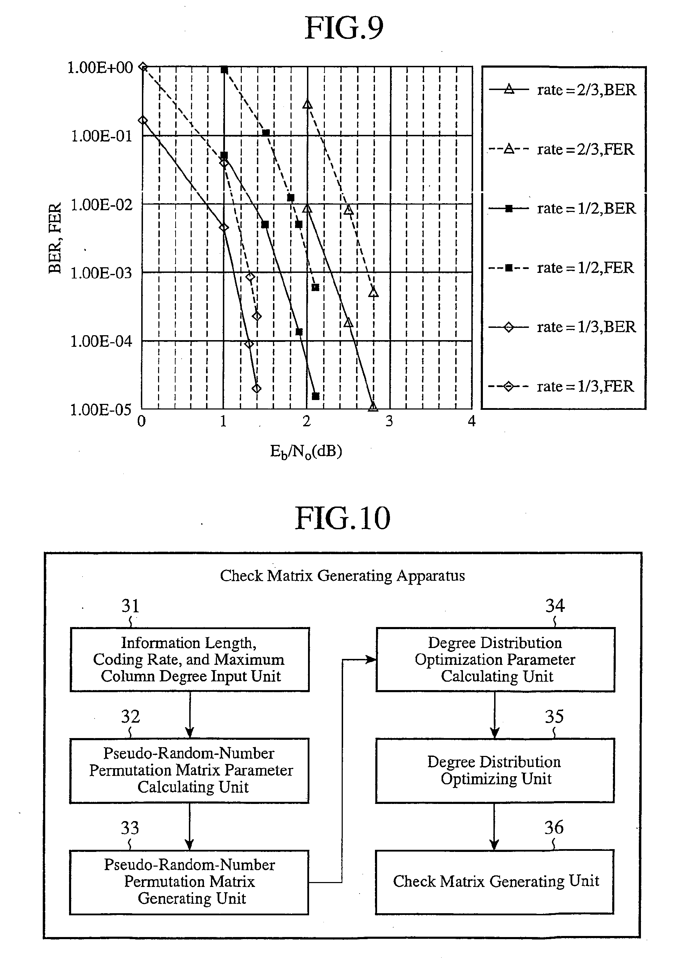

Fig. 9 is a diagram showing bit error rate (BER) characteristics and frame error rate (FER) characteristics for a signal power to noise power ratio (Eb/No) per 1 bit of information of an LDPC code which uses the check matrix generated by the check matrix generating apparatus in accordance with this embodiment 2. Hereafter, assume that the information length is 1536 bits, a communication path is AWGN, and the maximum number of iteration times is 200. As the decoding method, a "Sum-Product algorithm" is used. Those characteristics are obtained by using the check matrix for RC-LDPC codes which is generated using parameters $M_1$ to $M_3$ and $N_1$ to $N_3$, which will be shown below, according to the procedure of this embodiment 2. In this check matrix, $R(1)=1-M_1/N_1=1/3$, $R(2)=1-M_2/N_2=1/2$, and $R(3)=1-M_3/N_3=2/3$.

On the other hand, SNRs which are Shannon limits in the case of $R(1)=1/3$, $R(2)=1/2$, and $R(3)=2/3$ are -0.4954 (dB), 0. 1870 (dB), and 1. 0595 (dB), respectively, and the differences among them are about 1.8 (dB), 1.7 (dB), and 1.45 (dB) at BER=$10^{-4}$ points. Thus, the RC-LDPC codes which approach the Shannon limits can be implemented in spite of the fact that the information length is 536 bits, but not so long.

As mentioned above, according to this embodiment 2, the same advantage as offered by embodiment 1 is provided. While in accordance with embodiment 1 it is necessary to generate a check matrix individually for each coding rate, in accordance with this embodiment 2, there is provided an advantage of being able to easily generate a check matrix only by finally preparing one kind of check matrix for two or more coding rates.

Embodiment 3.

Fig. 10 is a block diagram showing the structure of a check matrix generating apparatus for LDPC codes in accordance with embodiment 3 of the present invention. This check matrix generating apparatus is provided with an information length, coding rate and maximum column degree input unit 31, a pseudo-random-number permutation matrix parameter calculating unit 32, a pseudo-random-number permutation matrix generating unit 33, a degree distribution optimization parameter calculating unit 34, a degree distribution optimizing unit 35, and a check matrix generating unit 36. This check matrix generating apparatus can be mounted in each of the communication apparatus on the transmit side of the system shown in Fig. 4 and that on the receive side of the system so that they can output generated check matrices to the encoder 101 and decoder 105, respectively. As an alternative, the check matrix generating apparatus can be mounted outside each of the communication apparatus on the transmit side of the system and that on the receive side of the system so that they can store generated check matrices in memories (not shown) in the communication apparatus on the transmit and receive sides of the system and output them to the encoder 101 and decoder 105, respectively.

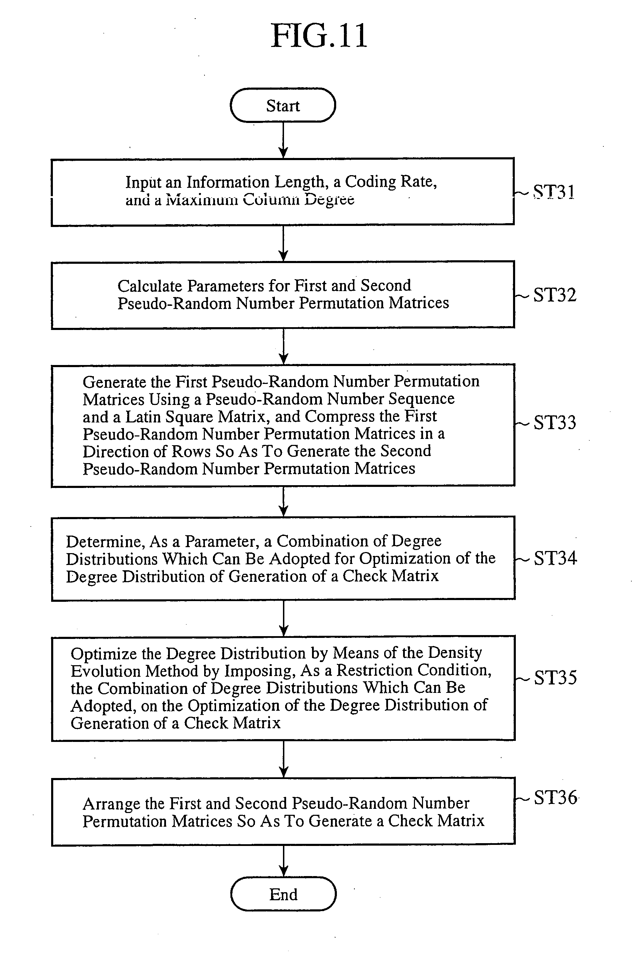

Fig. 11 is a flow chart showing a flow of processing carried out by the check matrix generating apparatus in accordance with embodiment 3 of the present invention. In step ST31, the information length, coding rate, and maximum column degree input unit 31 inputs a predetermined information length, a coding rate, and a maximum column degree.

In step ST32, the pseudo-random-number permutation matrix parameter calculating unit 32 calculates a parameter for first and second pseudo-random-number permutation matrices, which will be explained below, using the predetermined information length, coding rate, and maximum column degree which are inputted in above-mentioned step ST31.

In step ST33, the pseudo-random-number permutation matrix generating unit 33 generates first pseudo-random-number permutation matrices from the parameter for the first and second pseudo-random-number permutation matrices, which are calculated in above-mentioned step ST32, using a pseudo-random-number sequence and a Latin square matrix, and further compresses the first pseudo-random-number permutation matrices in the direction of rows so as to generate the second pseudo-random-number permutation matrices. In step ST34, using the predetermined information length, coding rate, and maximum column degree, which are inputted in above-mentioned step ST31, the degree distribution optimization parameter calculating unit 34 determines, as a parameter, a combination of degree distributions which can be adopted for optimization of the degree distribution of generation of a check matrix which can be constructed using the first and second pseudo-random-number permutation matrices.

In step ST35, the degree distribution optimizing unit 35 optimizes the degree distribution of generation of a check matrix by means of a density evolution method by imposing, as a restriction condition, the combination of the degree distributions which can be adopted, which is determined in above-mentioned step ST34, on the optimization of the degree distribution of generation of the check matrix. In step ST36, according to the degree distribution of generation of a check matrix, which is optimized in above-mentioned step ST35, the check matrix generating unit 26 arranges the first and second pseudo-random-number permutation matrices generated in above-mentioned step ST33 so as to generate a check matrix for LDPC codes.

Next, the details of processes in steps ST31 to ST36 in the flow chart of Fig. 11 will be explained.
In step ST31, the information length, coding rate, and maximum column degree input unit 31 inputs, as the predetermined information length, coding rate, and maximum column degree, an information length K=124, a coding rate rate=0.5, and a maximum column degree d=16 which are set up in advance in the system.

In step ST32, using the information length K=120, coding rate rate=0.5, and maximum column degree d=16, which are inputted in above-mentioned step ST31, the pseudo-random-number permutation matrix parameter calculating unit 32 calculates the number M of rows of the check matrix H, the number N of columns (=the coding rate), and a common parameter for the first and the second pseudo-random-number permutation matrices (i.e., p and b of the $p \cdot b \times p \cdot b$ pseudo-random number permutation matrices), as will be explained below.

[Equation 29]

Because a maximum number in the direction of rows of below-mentioned first pseudo-random numbers $BPS_{hop\_}I$, $BPS_{hop\_}II$, $BPS_{hop\_}III$, and $BPS_{hop\_}IV$ is 4 (as explained in step ST33-7), the remaining column degree d-4=12 is realized by $cw$=3 with the second pseudo-random number permutation matrices $cI_{cw}$, $cII_{cw}$, $cIII_{cw}$, and $cIV_{cw}$ which will be explained in the following step ST34. In the case of cw=3, the number of the pseudo-random number permutation matrices $cI_{cw}$, $cII_{cw}$, $cIII_{cw}$, and $cTV_{cw}$ being used = the remaining column degree 12/cw=4, and the combination of the four permutation matrices $cI_{cw}$, $cII_{cw}$, $cIII_{cw}$, and $cIV_{cw}$ is arranged in the direction of columns.

$$\text{The code length} = \text{the number N of columns of the check matrix H} = k/rate = 120/(1/3) = 360$$

$$\text{The number of rows of the check matrix H } M = N*(1-rate) = 360*(2/3) = 240$$

The size of each pseudo-random number permutation matrix $p \cdot b$=M/ (the number of pseudo-random number permutation matrices $BPS_{hop\_}I$, $BPS_{hop\_}II$, $BPS_{hop\_}III$, and $BPS_{hop\_}IV$ being used + the number of pseudo random number matrices $cI_{cw}$, $cII_{cw}$, $cIII_{cw}$, and $cIV_{cw}$ being used) =240/8=30. Therefore, for example, p= 6 and b= 5.

In step ST33, the pseudo-random-number permutation matrix generating unit 33 generates the first pseudo-random-number permutation matrices from the parameter for the first and second pseudo-random-number permutation matrices, which is calculated in above-mentioned step ST32, using a pseudo-random-number sequence and a Latin square matrix, and further compresses the first pseudo-random-number permutation matrices in the direction of rows so as to generate the second pseudo-random-number permutation matrices, as shown in below-mentioned steps ST33-1 to ST33-8.

[Equation 30]

That is, the first pseudo-random number permutation matrices $BPS_{hop\_}I$, $BPS_{hop\_}II$, $BPS_{hop\_}III$, and $BPS_{hop\_}IV$, and the second pseudo-random number permutation matrices $cl_{cw}$, $cll_{cw}$, $clll_{cw}$, and $clV_{cw}$ are generated from p and b which are calculated in above-mentioned step ST32.

[Step ST33-1]

[Equation 31]

A pseudo-random number sequence $C_{init}(i)$ defined by the following equation is generated. The index init shows the value of $C_{init}(1)$, i.e., an initial value.

$$C_{init}(1) = init, \quad C(i+1) = G_0 \times C(i) \bmod P, \quad i = 1,2,...,P-2,$$

where P is a prime number which is expressed as P>p, and Go is a primitive element of $GF(P)$. In a case in which successive powers of Go which are elements of $GF(P)$ (e.g., $G_0{}^1$, $G_0{}^2$, $\cdots$, $G_0{}^{P-1}=1$) are all non-zero elements of $GF(P)$, Go is called a primitive element. This sequence $C_{init}(i)$ is a pseudo-random number sequence in which the difference among its elements is ununiform, and no identical elements exist.

[Equation 32]

For example, in a case of $P$=7, $G_0$=3, and $init$=2,

$$
\begin{array}{cccccccc}
i: & 1 & 2 & 3 & 4 & 5 & 6 \\
C(i): & 3 & 2 & 6 & 4 & 5 & 1
\end{array}
$$

Next, numbers larger than p are removed from the elements of $C_{init}(i)$.
For example, in a case of p=5,

$$
\begin{array}{cccccc}
i: & 1 & 2 & 3 & 4 & 5 \\
C_{init}(i): & 3 & 2 & 4 & 5 & 1
\end{array}
$$

[Step ST33-2]

[Equation 33]

A Latin square matrix $L_j(q,l)$ having, elements, a pseudo-random number sequence and a permutation pattern of this sequence is generated according to the following equation:

$$L(q, ((q+i-2)\bmod(p))+1) = C(i),$$
$$i = 1,2,...,p, \quad q = 1,2,..,p.$$

With this operation, a Latin square matrix can be generated using $L(q, 1)$.
An example in a case of p=6 will be shown below.

$$
\begin{array}{lcccccc}
l: & 1 & 2 & 3 & 4 & 5 & 6 \\
L(1,l) & 3 & 2 & 6 & 4 & 5 & 1 \\
L(2,l) & 2 & 6 & 4 & 5 & 1 & 3 \\
L(3,l) & 6 & 4 & 5 & 1 & 3 & 2 \\
L(4,l) & 4 & 5 & 1 & 3 & 2 & 6 \\
L(5,l) & 5 & 1 & 3 & 2 & 6 & 4 \\
L(6,l) & 1 & 3 & 2 & 6 & 4 & 5
\end{array}
$$

For example, in a case of p=5, a Latin square matrix is given as follows.

$$
\begin{array}{lccccc}
l: & 1 & 2 & 3 & 4 & 5 \\
L(1,l) & 3 & 2 & 4 & 5 & 1 \\
L(2,l) & 2 & 4 & 5 & 1 & 3 \\
L(3,l) & 4 & 5 & 1 & 3 & 2 \\
L(4,l) & 5 & 1 & 3 & 2 & 4 \\
L(5,l) & 1 & 3 & 2 & 6 & 4 \\
L(6,l) & 3 & 2 & 6 & 4 & 5
\end{array}
$$

[Step ST33-3]

[Equation 34]

A fundamental permutation matrix pattern *BP(q, i)* is generated according to the following equation:

$$
BP(q,i) = L(q,i) + p \times (i-1),
$$
$$
i = 1,2,\ldots, p, \quad q = 1,2,\ldots, p.
$$

An example in a case of p=6 will be shown below.

$$
\begin{array}{lcccccc}
i: & 1 & 2 & 3 & 4 & 5 & 6 \\
BP(1,i) & 3 & 2 & 6 & 4 & 5 & 1 \\
BP(2,i) & 8 & 12 & 10 & 11 & 7 & 9 \\
BP(3,i) & 18 & 16 & 17 & 13 & 15 & 14 \\
BP(4,i) & 22 & 23 & 19 & 21 & 20 & 24 \\
BP(5,i) & 29 & 25 & 27 & 26 & 30 & 28 \\
BP(6,i) & 31 & 33 & 32 & 36 & 34 & 35
\end{array}
$$

[Step ST33-4]

[Equation 35]

*BP$_{hop}$(q,i)* in which a certain interval in each row of the fundamental permutation matrix pattern *BP(q,i)* is permutated is generated according to the following equation. The interval at the time of the permutation for each row is set to *hop.*

i) When b and hop are prime to each other,

$$BP_{hop}(q,i) = BP((hop*(q-1) \bmod b)+1, i)$$

ii) When b and hop are not prime to each other,

$$BP_{hop}(q,i) = BP((hop*(q-1) \bmod b)+1+\lfloor i/b \rfloor, i)$$

An example in a case of b=5 and *hop*=2 will be shown below.

| $i:$ | 1 | 2 | 3 | 4 | 5 | 6 |
|---|---|---|---|---|---|---|
| $BP_{hop}(1,i)$ | 3 | 2 | 6 | 4 | 5 | 1 |
| $BP_{hop}(2,i)$ | 18 | 16 | 17 | 13 | 15 | 14 |
| $BP_{hop}(3,i)$ | 29 | 25 | 27 | 26 | 30 | 28 |
| $BP_{hop}(4,i)$ | 8 | 12 | 10 | 11 | 7 | 9 |
| $BP_{hop}(5,i)$ | 22 | 23 | 19 | 21 | 20 | 24 |

[Step ST33-5]

[Equation 36]

A fundamental permutation sequence $BPS_{hop}$ (i) is generated from the fundamental permutation matrix pattern $BPS_{hop}(q,i)$ according to the following equation:

$$BPS_{hop}(j+(i-1)*b) = BP_{hop}(j,i),$$
$$j = 1,2,...,b, \quad i = 1,2,...,p.$$

With this operation, a position vector for a column corresponding to a row at the position of each "1" of the fundamental permutation matrix for generating a $p{\cdot}b \times p{\cdot}b$ matrix with column degree 1 and row degree 1 can be generated.

An example will be shown below.

[Equation 37]

$$
\begin{array}{ccccccc}
i: & 1 & 2 & 3 & 4 & 5 & 6 \\
BPS_{hop}(i) & 3 & 18 & 29 & 8 & 22 & 2
\end{array}
$$

$$
\begin{array}{ccccccc}
i: & 7 & 8 & 9 & 10 & 11 & 12 \\
BPS_{hop}(i) & 16 & 25 & 12 & 23 & 6 & 17
\end{array}
$$

$$
\begin{array}{ccccccc}
i: & 13 & 14 & 15 & 16 & 17 & 18 \\
BPS_{hop}(i) & 27 & 10 & 19 & 4 & 13 & 26
\end{array}
$$

$$
\begin{array}{ccccccc}
i: & 19 & 20 & 21 & 22 & 23 & 24 \\
BPS_{hop}(i) & 11 & 21 & 5 & 15 & 30 & 7
\end{array}
$$

$$
\begin{array}{ccccccc}
i: & 25 & 26 & 27 & 28 & 29 & 30 \\
BPS_{hop}(i) & 20 & 1 & 14 & 28 & 9 & 24
\end{array}
$$

[Step ST33-6]

[Equation 38]

A binary p·b×p·b matrix $BPS_{hop}=(h_{m,n})$ which is defined by the following equation is generated from the fundamental permutation sequence $BPS_{hop}(i)$.

$$
h_{m,n} := \begin{cases} 1, & \text{if } n = BPS_{hop}(m) \\ 0, & \text{otherwise} \end{cases}
$$

With this operation, a fundamental permutation matrix for generating a $p \cdot b \times p \cdot b$ matrix with column degree 1 of and row degree 1 can be generated. With the operations carried out until now, pseudo-random number permutation matrices in which the distance between any adjacent elements is long and the distance between any two elements is ununiform can be generated.

By increasing the distance between any adjacent elements, the occurrence of the short cycles which can occur in the lower triangular matrix of T previously explained in embodiment 1 can be prevented. Furthermore, by making the distance between any two elements be ununiform, the occurrence of the short cycles can be also suppressed in the above-mentioned $p \cdot b \times p \cdot b$ fundamental permutation matrices. When the $p \cdot b \times p \cdot b$ fundamental permutation matrices which have been generated in order to prevent the occurrence of cycle 4 are recognized, and cycle 4 exists, by varying $p$, $b$, $G_0$, init, and hop, a combination of the parameters in which cycle 4 does not exist is searched for and the pseudo-random number permutation matrices are regenerated. However, the procedure according to this embodiment rarely causes the occurrence of cycle 4, and it is hardly necessary to carry out regeneration of the pseudo-random number permutation matrices.

An example will be shown below.

$$BPS_{hop} = \begin{bmatrix} 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & \cdots \\ 0 & 0 & 0 & 0 & 0 & 0 & 0 & 0 & 0 & 0 & 0 & 0 & 0 & 0 & 0 & 0 & 0 & 0 & 1 & 0 & 0 & 0 & 0 & 0 & 0 & 0 & \cdots \\ \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots & \vdots \\ 0 & 0 & 0 & 0 & 0 & 0 & 0 & 0 & 1 & 0 & 0 & 0 & 0 & 0 & 0 & 0 & 0 & 0 & 0 & 0 & 0 & 0 & 0 & 0 & 0 & 0 & \cdots \\ 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 0 & 1 & \cdots \end{bmatrix}$$

[Step ST33-7]

[Equation 39]

From the fundamental permutation matrix $BPS_{hop}$, four types of fundamental permutation matrices $BPS_{hoP\_}I$, $BPS_{hop\_}II$. $BPS_{hop\_}III$, and $BPS_{hop\_}IV$ are generated.

$$i)\ BPS_{hop}\_I(p \cdot b - BPS_{hop}(i)+1, i) = 1, \qquad i = 1,2,\ldots, p \cdot b$$

All other elements of $BPS_{hop\_}I$ are zero.

$$ii)\ BPS_{hop}\_II(j,i) = BPS_{hop}\_I(i, p \cdot b - j + 1), \qquad i = 1,2,\ldots, p \cdot b, \qquad j = 1,2,\ldots, p \cdot b$$

$$iii)\ BPS_{hop}\_III(j,i) = BPS_{hop}\_II(i, p \cdot b - j + 1), \qquad i = 1,2,\ldots, p \cdot b, \qquad j = 1,2,\ldots, p \cdot b$$

$$iv)\ BPS_{hop}\_IV(j,i) = BPS_{hop}\_III(i, p \cdot b - j + 1), \qquad i = 1,2,\ldots, p \cdot b, \qquad j = 1,2,\ldots, p \cdot b$$

All these matrices ii), iii), and iv) are the $p \cdot b \times p \cdot b$ ones with column degree 1 and row degree 1 in which the rows and columns are permutated based on $BPS_{hop\_}I$. From the combination of these matrices, matrices including matrices with column degrees and row degrees from column degree 1 and row degree 1 to degree 4 and row degree 4 can be generated. Four different types of pseudo-random-number permutation matrices can be generated through this permutation between the rows and the columns.

[Step ST33-8]

Next, a basic permutation matrix with a column degree higher than 1 will be generated.

[Equation 40]

By using the fundamental permutation matrix $BPS_{hop\_}I$ obtained in step ST33-7, the $(p \cdot b) \times (p \cdot b / cw)$ pseudo-random number permutation matrix $cl_{cw}$ with column degree cw and row degree 1 is generated according to the following procedure. At this time, the columns of the matrix are compressed to $1/cw$. That is, the matrix is compressed in the direction of rows.

$$cI_{cw} = BPS_{hop}\_I \cdot \begin{bmatrix} I \\ \vdots \\ I \end{bmatrix}_{p \cdot b \times p \cdot b / cw}$$

where I is a $(p \cdot b / cw) \times (p \cdot b / cw)$ unit matrix.

According to the same procedure, the fundamental permutation matrices $cII_{cw}$, $cIII_{cw}$, and $cIV_{cw}$ with column degree $cw$ and row degree 1 are generated using the fundamental permutation matrices $BPS_{hop}\_II$, $BPShop\_III$, and $BPS_{hoP}\_IV$. In a case in which two or more combinations of $cI_{cw}$, $cII_{cw}$, $cIII_{cw}$, and $cIV_{cw}$ are arranged in the direction of columns, they are arranged in line only in the direction of rows because it is clear that cycle 4 occurs.

In step ST34, using the predetermined information length, coding rate, and maximum column degree, which are inputted in above-mentioned step ST31, the degree distribution optimization parameter calculating unit 34 determines, as a parameter, a combination of degree distributions which can be adopted for optimization of the degree distribution of generation of a check matrix which can be constructed using the first and second pseudo-random-number permutation matrices.

[Equation 41]

By using $BPS_{hop}\_I$, $BPS_{hop}\_II$, $BPS_{hop}\_III$, and $BPS_{hop}\_IV$, the combination of $cI_{cw}$, $cII_{cw}$, $cIII_{cw}$, and $cIV_{cw}$, and a triangular matrix whose elements in an upper right triangle area are all 0, a realizable combination is determined. For example, in the below-mentioned check matrix H, the (4x4) pseudo-random number permutation matrices $BPS_{hop}\_I$, $BPS_{hop}\_II$, $BPS_{hop}\_III$, and $BPS_{hop}\_IV$, and the $(4 \times 1)$ (in the case of $cw$=3) pseudo-random number permutation matrices $cI_{cw}$, $cII_{cw}$, $cIII_{cw}$, and $cIV_{cw}$ can be arranged in a left end portion, and (7+6+ ... +1) pseudo-random-number permutation matrices $BPS_{hop}\_I$, $BPS_{hop}\_II$, $BPS_{hop}\_III$, and $BPS_{hop}\_IV$ can be arranged in a lower left triangular portion on a right-hand side of the check matrix.

$$H = \begin{bmatrix} BPS_{hop}\_III & BPS_{hop}\_II & BPS_{hop}\_I & BPS_{hop}\_IV & \diagdown & 0 & 0 & 0 & 0 & 0 & 0 & 0 \\ BPS_{hop}\_II & BPS_{hop}\_I & BPS_{hop}\_IV & BPS_{hop}\_III & 0 & \diagdown & 0 & 0 & 0 & 0 & 0 & 0 \\ BPS_{hop}\_I & BPS_{hop}\_IV & BPS_{hop}\_III & BPS_{hop}\_II & 0 & 0 & \diagdown & 0 & 0 & 0 & 0 & 0 \\ BPS_{hop}\_IV & BPS_{hop}\_III & BPS_{hop}\_II & BPS_{hop}\_I & 0 & 0 & 0 & \diagdown & 0 & 0 & 0 & 0 \\ cI_{cw} & 0 & 0 & 0 & 0 & 0 & 0 & 0 & \diagdown & 0 & 0 & 0 \\ cVI_{cw} & 0 & 0 & 0 & 0 & 0 & 0 & 0 & 0 & \diagdown & 0 & 0 \\ cIII_{cw} & 0 & 0 & 0 & 0 & 0 & 0 & 0 & 0 & 0 & \diagdown & 0 \\ cII_{cw} & 0 & 0 & 0 & 0 & 0 & 0 & 0 & 0 & 0 & 0 & \diagdown \end{bmatrix}$$

In step ST35, the degree distribution optimizing unit 35 optimizes the degree distribution of generation of a check matrix by means of a density evolution method by imposing, as a restriction condition, the combination of the degree distributions which can be adopted, which is determined in above-mentioned step ST34, on the optimization of the degree distribution of generation of the check matrix, as in the case of step ST15 of embodiment 1.

In step ST36, according to the degree distribution of generation of a check matrix, which is optimized in above-mentioned step ST35, the check matrix generating unit 26 arranges the first and second pseudo-random-number permutation matrices generated in above-mentioned step ST33 so as to generate a check matrix for LDPC codes.

[Equation 42]

That is, by using the combination of the optimal degree distributions calculated in step ST35, the check matrix H is generated from the first pseudo-random number permutation matrices $BPS_{hop}\_I$, $BPS_{hop}\_II$, $BPS_{hop}\_III$, and $BPS_{hop}\_IV$, and the second pseudo-random number permutation matrices $cI_{cw}$, $cII_{cw}$, $cIII_{cw}$, and $cIV_{cw}$. A proper position of each pseudo random number permutation matrix is determined by checking the number of cycles through search and so on.

As mentioned above, this embodiment 3 provides the same advantages as offered by embodiment 1.

Embodiment 4.

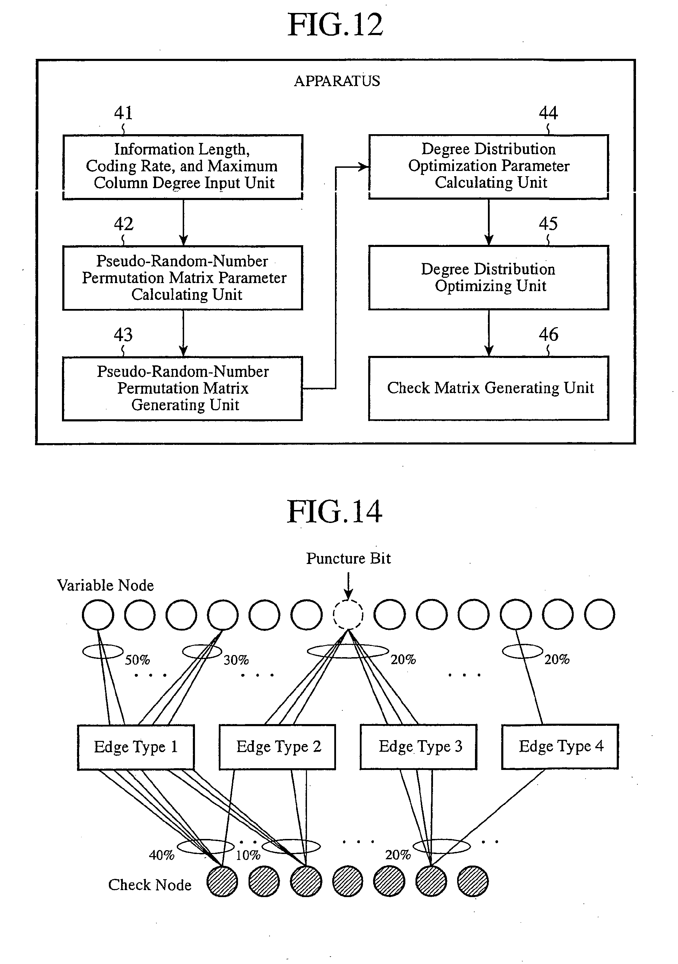

Fig. 12 is a block diagram showing the structure of a check matrix generating apparatus for LDPC codes in accordance with embodiment 4 of the present invention. This check matrix generating apparatus is provided with an information length, coding rate and maximum column degree input unit 41, a pseudo-random-number permutation matrix parameter calculating unit 42, a pseudo-random-number permutation matrix generating unit 43, a degree distribution optimization parameter calculating unit 44, a degree distribution optimizing unit 45, and a check matrix generating unit 46. This check matrix generating apparatus can be mounted in each of the communication apparatus on the transmit side of the system shown in Fig. 4 and that on the receive side of the system so that they can output generated check matrices to the encoder 101 and decoder 105, respectively. As an alternative, the check matrix generating apparatus can be mounted outside each of the communication apparatus on the transmit side of the system and that on the receive side of the system so that they can store generated check matrices in memories (not shown) in the communication apparatus on the transmit and receive sides of the system and output them to the encoder 101 and decoder 105, respectively.

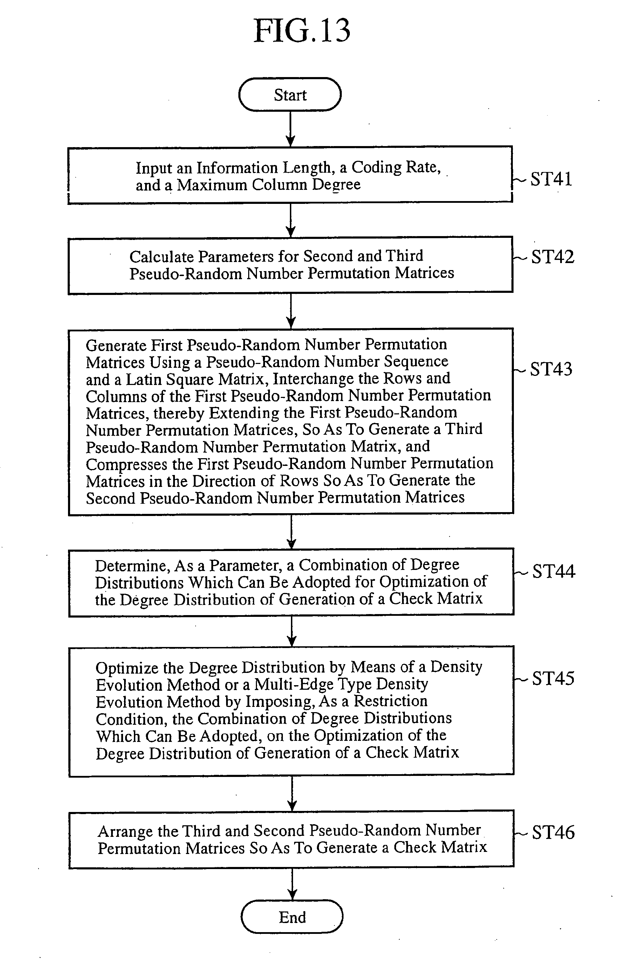

Fig. 13 is a flow chart showing a flow of processing carried out by the check matrix generating apparatus in accordance with embodiment 4 of the present invention.

[Equation 43]

In accordance with embodiment 3, by using $BPS_{hop\_}I, BPS_{hop\_}II, BPS_{hop\_}III,$ and $BPS_{hop\_}IV,$ for example, a matrix with column degree 4 and row degree 4 is generated. In contrast, in accordance with embodiment 4, by using $ELHP_{(cw',rw')}$ which will be mentioned below, a matrix with column degree $cw'$ and row degree $rw'$ is directly generated.

In step ST41, the information length, coding rate, and maximum column degree input unit 31 inputs a predetermined information length, a coding rate, and a maximum column degree. In step ST42, the pseudo-random-number permutation matrix parameter calculating unit 42 calculates a parameter for a third pseudo-random-number permutation matrix, which will be explained below, and a parameter for second pseudo-random-number permutation matrices, which are the same as those of embodiment 2, using the predetermined information length, coding rate, and maximum column degree which are inputted in above-mentioned step ST41.

In step ST43, the pseudo-random-number permutation matrix generating unit 43 generates first pseudo-random-number permutation matrices from the parameter for the third pseudo-random-number permutation matrix and the parameter for the second pseudo-random-number permutation matrices, which are calculated in above-mentioned step ST42, using a pseudo-random-number sequence and a Latin square matrix, and further interchanges the rows and columns of the generated first pseudo-random-number permutation matrices, thereby extending these first pseudo-random-number permutation matrices, so as to generate the third pseudo-random-number permutation matrix, and compresses the generated first pseudo-random-number permutation matrices in the direction of rows so as to generate the second pseudo-random-number permutation matrices. In step ST44, using the predetermined information length, coding rate, and maximum column degree, which are inputted in above-mentioned step ST41, the degree distribution optimization parameter calculating unit 44 determines, as a parameter, a combination of degree distributions which can be adopted for optimization of the degree distribution of generation of a check matrix.

In step ST45, the degree distribution optimizing unit 45 optimizes the degree distribution of generation of a check matrix by means of either a density evolution method or a Multi-edge type density evolution method by imposing, as a restriction condition, the combination of the degree distributions which can be adopted, which is determined in above-mentioned step ST44, on the optimization of the degree distribution of generation of the check matrix. In step ST46, according to the degree distribution of generation of a check matrix, which is optimized in above-mentioned step ST45, the check matrix generating unit 46 arranges the third and second pseudo-random-number permutation matrices generated in above-mentioned step ST43 so as to generate a check matrix for LDPC codes.

Next, the details of processes in steps ST41 to ST46 in the flow chart of Fig. 13 will be explained.

In step ST41, the information length, coding rate, and maximum column degree input unit 41 inputs, as the predetermined information length, coding rate, and maximum column degree, an information length K=120, a coding rate rate=0.5, and a maximum column degree d=16 which are set up in advance in the system.

In step ST42, using the information length K=120, coding rate rate=0.5, and maximum column degree d=16, which are inputted in above-mentioned step ST41, the pseudo-random-number permutation matrix parameter calculating unit 42 calculates the number M of rows of the check matrix H, the number N of columns (=the coding rate), and a parameter for the third pseudo-random-number permutation matrix and a parameter for the second pseudo-random-number permutation matrices, as will be explained below.

That is, in that step,

[Equation 44]

By using the data inputted in step ST41, the number M of rows of the check matrix H, the number of columns (=code length) N of the check matrix H, and $p'$ and $b'$ of the third $p' \cdot b' x p' \cdot b'$ pseudo-random number permutation matrix $ELHP_{(cw',rw')}$ with column weight $cw'$ and row weight $rw'$ are calculated, and $p$, $b$ and $cw$ of the second $(p \cdot b) \times (p \cdot b/cw)$ pseudo-random number permutation matrices $cI_{cw}$, $cII_{cw}$, $cIII_{cw}$, and $cIV_{cw}$ are calculated.

For example, the pseudo-random-number permutation matrix parameter calculating unit calculates a parameter for the third pseudo-random-number permutation matrix and a parameter for the second pseudo-random-number permutation matrices as follows.

[Equation 45]

After the same calculation as that in step ST32 of embodiment 3 is carried out, the pseudo-random number permutation matrices $BPS_{hop\_}I$, $BPS_{hop\_}II$, $BPS_{hop\_}III$, and $BPS_{hop\_}IV$ are replaced by the pseudo-random number permutation matrix $ELHP_{(cw',rw')}$ explained in the below-mentioned steps ST43-1 and ST43-9.

Because the maximum number in the direction of rows of the pseudo-random number permutation matrices $BPS_{hop\_}I$, $BPS_{hop\_}II$, $BPS_{hop\_}III$, and $BPS_{hop\_}IV$ is 4 (as explained in step ST33-7 of embodiment 3), the remaining column degree d-4=12 is realized by cw=3 with the pseudo-random number permutation matrices $cI_{cw}$, $cII_{cw}$, $cIII_{cw}$, and $cIV_{cw}$ which will be explained in the below-mentioned step ST44. In the case of $cw$=3, the number of the pseudo-random number permutation matrices $cI_{cw}$, $cII_{cw}$, $cIII_{cw}$, and $cIV_{cw}$ being used = the remaining column degree 12/cw=4, and the combination of the four permutation matrices $cI_{cw}$, $cII_{cw}$, $cIII_{cw}$, and $cIV_{cw}$ is arranged in the direction of columns.

```
The code length = the number N of columns of the check matrix H = k/rate=120/(1/3) =360


The   number   of   rows   of   the   check   matrix   H M=N*(1-rate)=360*(2/3)=240
```

The size of each pseudo-random number permutation matrix $p \cdot b$=M/(the number of the pseudo-random number permutation matrices $BPS_{hop\_}I$, $BPS_{hop\_}II$, $BPS_{hoP\_}III$, and $BPS_{hop\_}IV$ being used + the number of the pseudo random number matrices $cI_{cw}$, $cII_{cw}$, $cIII_{cw}$, and $cIV_{cw}$ being used) =240/8=30. Therefore, for example, the parameters for generating the first and second pseudo-random number permutation matrices are p=6 and b= 5.

These values are the same as the values of p and b which are calculated in embodiment 3, and the following check matrix H is assumed.

$$H = \begin{bmatrix} BPS_{hop}\_III & BPS_{hop}\_II & BPS_{hop}\_I & BPS_{hop}\_IV & \diagdown & 0 & 0 & 0 & 0 & 0 & 0 & 0 \\ BPS_{hop}\_II & BPS_{hop}\_I & BPS_{hop}\_IV & BPS_{hop}\_III & 0 & \diagdown & 0 & 0 & 0 & 0 & 0 & 0 \\ BPS_{hop}\_I & BPS_{hop}\_IV & BPS_{hop}\_III & BPS_{hop}\_II & 0 & 0 & \diagdown & 0 & 0 & 0 & 0 & 0 \\ BPS_{hop}\_IV & BPS_{hop}\_III & BPS_{hop}\_II & BPS_{hop}\_I & 0 & 0 & 0 & \diagdown & 0 & 0 & 0 & 0 \\ cI_{cw} & 0 & 0 & 0 & 0 & 0 & 0 & 0 & \diagdown & 0 & 0 & 0 \\ cVI_{cw} & 0 & 0 & 0 & 0 & 0 & 0 & 0 & 0 & \diagdown & 0 & 0 \\ cIII_{cw} & 0 & 0 & 0 & 0 & 0 & 0 & 0 & 0 & 0 & \diagdown & 0 \\ cII_{cw} & 0 & 0 & 0 & 0 & 0 & 0 & 0 & 0 & 0 & 0 & \diagdown \end{bmatrix}$$

In this check matrix H, the following $4 \cdot p \cdot b \times 4 \cdot p \cdot b$ submatrix with column degree 4 and row degree 4 which are comprised of the pseudo-random number permutation matrices $BPS_{hop\_}I$, $BPS_{hop\_}II$, $BPS_{hop\_}III$, and $BPS_{hop\_}IV$:

$$\begin{bmatrix} BPS_{hop}\_III & BPS_{hop}\_II & BPS_{hop}\_I & BPS_{hop}\_IV \\ BPS_{hop}\_II & BPS_{hop}\_I & BPS_{hop}\_IV & BPS_{hop}\_III \\ BPS_{hop}\_I & BPS_{hop}\_IV & BPS_{hop}\_III & BPS_{hop}\_II \\ BPS_{hop}\_IV & BPS_{hop}\_III & BPS_{hop}\_II & BPS_{hop}\_I \end{bmatrix}$$

is replaced by the $p'\cdot b'\times p'\cdot b'=4\cdot p\cdot b\times 4\cdot p\cdot b$ pseudo-random number permutation matrix $ELHP_{(cw'=4, rw'=4)}$ with column degree cw'=4 and row -degree rw'=4, as shown in the following check matrix H .

$$H = \begin{bmatrix} \begin{matrix} ELHP_{(cw'=4,\, rw'=4)} \\ cI_{cw} & 0 & 0 & 0 \\ cVI_{cw} & 0 & 0 & 0 \\ cIII_{cw} & 0 & 0 & 0 \\ cII_{cw} & 0 & 0 & 0 \end{matrix} & \begin{matrix} \searrow & 0 & 0 & 0 & 0 & 0 & 0 & 0 \\ 0 & \searrow & 0 & 0 & 0 & 0 & 0 & 0 \\ 0 & 0 & \searrow & 0 & 0 & 0 & 0 & 0 \\ 0 & 0 & 0 & \searrow & 0 & 0 & 0 & 0 \\ 0 & 0 & 0 & 0 & \searrow & 0 & 0 & 0 \\ 0 & 0 & 0 & 0 & 0 & \searrow & 0 & 0 \\ 0 & 0 & 0 & 0 & 0 & 0 & \searrow & 0 \\ 0 & 0 & 0 & 0 & 0 & 0 & 0 & \searrow \end{matrix} \end{bmatrix}$$

Therefore, for example, from p=6 and $b$=5, $p'\cdot b'$=4, $p\cdot$ b=4, and 30=120 are obtained. Therefore, for example, the parameters for generating the third pseudo-random number permutation matrix are p'=12 and b'=10.

In step ST43, the pseudo-random-number permutation matrix generating unit 43 generates the first pseudo-random number permutation matrices from the parameter for the third pseudo-random-number permutation matrix and the parameter for the second pseudo-random-number permutation matrices, which are calculated in above-mentioned step ST42, using a pseudo-random-number sequence and a Latin square matrix (i.e., generates the first pseudo-random number permutation matrices from the parameter common to that for the second pseudo-random-number permutation matrices), further interchanges the rows and columns of the generated first pseudo-random-number permutation matrices, thereby extending these first pseudo-random-number permutation matrices, so as to generate the third pseudo-random-number permutation matrix.

[Equation 46]

That is, in below-mentioned steps ST43-1 to ST43-9, the third pseudo-random number permutation matrix $ELHP_{(cw',rw')}$ is generated from p' and b' which are calculated in step ST42.

The method of, in this step ST43, further compressing the first pseudo-random-number permutation matrices in the direction of rows so as to generate the second pseudo-random-number permutation matrices is the same as that used in the processes of steps ST33-1 to ST33-8 of embodiment 3.

[Step ST43-1]

[Equation 47]

A pseudo-random number sequence $C_{init}(i)$ defined by the following equation is generated. The index init shows the value of $C_{init}(1)$, i.e., an initial value.

$$C_{init}(1) = init, \quad C_{init}(i+1) = G_0 \times C_{init}(i) \bmod P, \quad i = 1,2,\ldots,P-2,$$

where P is a prime number which satisfies $P>p'$, and $G_0$ is the primitive element of $GF(P)$ In a case in which successive powers of Go which are elements of $GF(P)$ (e.g., $G_0{}^1$, $G_0{}^2$, ..., $G_0{}^{p-1}$=1) are all non-zero elements of $GF(P)$ , Go is called the primitive element. This sequence $C_{init}(i)$ is a pseudo-random number sequence in which the difference among its elements is ununiform, and no identical elements exist. Next, numbers larger than p' are removed from the elements of

$C_{init}(i)$.

As an example, a case of $P=7$, $G_0=3$, $init=3$, and $p'=6$ will be shown as follows:

$$
\begin{array}{rcccccc}
i: & 1 & 2 & 3 & 4 & 5 & 6 \\
C_3(i): & 3 & 2 & 6 & 4 & 5 & 1
\end{array}
$$

[Step ST43-2]

The pseudo-random-number sequence and a matrix having elements which are a permutation pattern of the pseudo-random-number sequence are generated according to the following equation:

[Equation 48]

$$
LH(j,(j \times i) \bmod (P)) = C_{init}(i),
$$
$$
i = 1,2,...,p, \quad j = 1,2,..,p.
$$

An example in a case of $p'=6$ will be shown below.

$$
\begin{array}{rcccccc}
l: & 1 & 2 & 3 & 4 & 5 & 6 \\
LH(1,l) & 3 & 2 & 6 & 4 & 5 & 1 \\
LH(2,l) & 4 & 3 & 5 & 2 & 1 & 6 \\
LH(3,l) & 5 & 6 & 3 & 1 & 4 & 2 \\
LH(4,l) & 2 & 4 & 1 & 3 & 6 & 5 \\
LH(5,l) & 5 & 1 & 2 & 5 & 3 & 4 \\
LH(6,l) & 1 & 5 & 4 & 6 & 2 & 3
\end{array}
$$

[Step ST43-3]

[Equation 49]

A fundamental permutation matrix pattern $LHP_{(cw',rw')}(j,i)$ with column degree $cw'$ and row degree $rw'$ is generated according to the following equation:

$$
LHP_{(cw,rw)}((i-1)*p/cw+j,k) = LH(i,(j-1)*cw+k),
$$
$$
i = 1,2,...,rw, \quad j = 1,2,..,p/cw, \quad k = 1,2,..,cw.
$$

An example in a case of $p'=6$ will be shown below.

$$
\begin{array}{lccc}
i: & 1 & 2 & 3 \\
LHP_{(3,3)}(1,i) & 3 & 2 & 6 \\
LHP_{(3,3)}(2,i) & 4 & 5 & 1 \\
LHP_{(3,3)}(3,i) & 4 & 3 & 5 \\
LHP_{(3,3)}(4,i) & 2 & 1 & 6 \\
LHP_{(3,3)}(5,i) & 5 & 6 & 3 \\
LHP_{(3,3)}(6,i) & 1 & 4 & 2 \\
\end{array}
$$

[Step ST43-4]

[Equation 50]

After up to the above-mentioned step ST43-3 is carried out, a $p' \times p'$ fundamental permutation matrix pattern is generated. Next, a procedure for multiplying this pattern by b' for the rows and columns will be explained.

A fundamental random number sequence $C_{init}^{b}(i)$ is generated according to the same procedure as that of step ST43-1.

This fundamental random number sequence $C_{init}^{b}(i)$ is the one in which p' is replaced by b' in $C_{init}(i)$.

A case in which $P=7$, $G_0=3$, $init=3$, and $p'=6$ will be shown below as an example.

$$
\begin{array}{lcccccc}
i: & 1 & 2 & 3 & 4 & 5 & 6 \\
C_3^6(i): & 3 & 2 & 6 & 4 & 5 & 1 \\
\end{array}
$$

[Step ST43-5]

[Equation 51]

A Latin square matrix $L_j(q, 1)$ having, elements, the pseudo-random number sequence and a permutation pattern of this sequence is generated according to the following equation:

$$
L^b(q, ((q+i-2)\bmod(p))+1) = C_{init}^{b}(i),
$$
$$
i = 1, 2, \ldots, p, \quad q = 1, 2, \ldots, p.
$$

With this operation, a Latin square matrix can be generated using $L^h(q,l)$.
An example in a case of $p'=6$ will be shown below.

$$
\begin{array}{lcccccc}
l: & 1 & 2 & 3 & 4 & 5 & 6 \\
L^b(1,l) & 3 & 2 & 6 & 4 & 5 & 1 \\
L^b(2,l) & 2 & 6 & 4 & 5 & 1 & 3 \\
L^b(3,l) & 6 & 4 & 5 & 1 & 3 & 2 \\
L^b(4,l) & 4 & 5 & 1 & 3 & 2 & 6 \\
L^b(5,l) & 5 & 1 & 3 & 2 & 6 & 4 \\
L^b(6,l) & 1 & 3 & 2 & 6 & 4 & 5 \\
\end{array}
$$

[Step ST43-6]

[Equation 52]

A matrix $L^{b'}P_{(cw',rw')}(j,i)$ for multiplying the fundamental permutation matrix pattern $LHP_{(cw',rw')}(j,i)$ with column degree *cw'* and row degree *rw'* by *b'* is generated according to the following equation:

$$L^b P_{(cw,rw)}((i-1)*p/cw+j,k) = L^b(i,(j-1)*cw+k),$$
$$i = 1,2,...,rw, \quad j = 1,2,.., p/cw, \quad k = 1,2,.., cw.$$

An example in a case of *p'*=6 will be shown below.

$$
\begin{array}{cccc}
i: & 1 & 2 & 3 \\
L^b P_{(3,3)}(1,i) & 3 & 2 & 6 \\
L^b P_{(3,3)}(2,i) & 4 & 5 & 1 \\
L^b P_{(3,3)}(3,i) & 2 & 6 & 4 \\
L^b P_{(3,3)}(4,i) & 5 & 1 & 3 \\
L^b P_{(3,3)}(5,i) & 6 & 4 & 5 \\
L^b P_{(3,3)}(6,i) & 1 & 3 & 2 \\
\end{array}
$$

[Step ST43-7]

[Equation 53]

A fundamental permutation matrix pattern $eLHP_{(cw',rw')}(i,j)$ for extension in the direction of columns is generated according to the following equation:

$$eLHP_{(cw,rw)}(i,j) = LHP_{(cw,rw)}(i,j) + ((L^b P_{(3,3)}(i,j)-1)*p),$$
$$i = 1,2,..., p*rw/cw, \quad j = 1,2,.., cw.$$

An example in a case of *p'*=6, *b'*=6, *cw'*=3, and *rw'*=3 will be shown below.

$$
\begin{array}{cccc}
i: & 1 & 2 & 3 \\
eLHP_{(3,3)}(1,i) & 15 & 8 & 36 \\
eLHP_{(3,3)}(2,i) & 22 & 29 & 1 \\
eLHP_{(3,3)}(3,i) & 10 & 33 & 23 \\
eLHP_{(3,3)}(4,i) & 26 & 1 & 18 \\
eLHP_{(3,3)}(5,i) & 35 & 24 & 27 \\
eLHP_{(3,3)}(6,i) & 1 & 16 & 8 \\
\end{array}
$$

[Step ST43-8]

[Equation 54]

A fundamental permutation matrix pattern $ELHP_{(cw',rw')}(i,j)$ for extension in the direction of rows is generated according to the following equation:

$$ELHP_{(cw,rw)}((j-1)\cdot b+i,k) = ((eLHP_{(cw,rw)}(j,k)+(i-1)\cdot p-1) \bmod \quad p\cdot b)+1,$$
$$i=1,2,...,b, \quad j=1,2,.., p\cdot rw/cw, \quad k=1,2,.., cw.$$

An example in the case of *p'*=6, *b'*=6, cw'=3, and rw'=3 will be shown below.

$$
\begin{array}{cccc}
i: & 1 & 2 & 3 \\
ELHP_{(3,3)}(1,i) & 15 & 8 & 36 \\
ELHP_{(3,3)}(2,i) & 21 & 14 & 6 \\
ELHP_{(3,3)}(3,i) & 27 & 20 & 12 \\
\vdots & \vdots & \vdots & \vdots \\
ELHP_{(3,3)}(35,i) & 25 & 4 & 32 \\
ELHP_{(3,3)}(36,i) & 31 & 10 & 2 \\
\end{array}
$$

[Step ST43-9]

[Equation 55]

From the fundamental permutation matrix pattern $ELHP_{(cw',rw')}(i,j)$, a binary $p'\cdot b'\times p'\cdot b'$ matrix $ELHP_{(cw',rw')}=(h_{m,n})$ defined by the following equation is generated.

$$h_{m,n} := \begin{cases} 1, & \text{if } n = ELHP_{(cw,rw)}(m) \\ 0, & \text{otherwise} \end{cases}$$

With this operation, a fundamental permutation matrix for generating the $p'\cdot b'\times p'\cdot b'$ matrix with column degree *cw'* and row degree *rw* can be generated. With the operations carried out until now, the pseudo permutation matrix with column degree *cw'* and row degree *rw'* can be generated. Because in most cases cycle 4 does not exist if both of the column degree *cw'* and row degree *rw'* of this pseudo permutation matrix are equal to or less than 4, both of the maximum of the column degree *cw'* and the maximum of the row degree *rw'* are set to 4.

In step ST44, using the predetermined information length, coding rate, and maximum column degree, which are inputted in above-mentioned step ST41, the degree distribution optimization parameter calculating unit 44 determines, as a parameter, a combination of degree distributions which can be adopted for optimization of the degree distribution of generation of a check matrix, as will be explained below.

[Equation 56]

By using $ELHP_{(cw',rw')}$, the combination of $cI_{cw}$, $cII_{cw}$, $cIII_{cw}$, and $cIV_{cw}$, and a triangular matrix whose elements in an upper right triangle area are all 0, a realizable combination is determined.

For example, in the below-mentioned check matrix H, one pseudo-random number permutation matrix $ELHP_{(cw',rw')}$, and (4×1) (in the case of *cw*=3) pseudo-random number permutation matrices $cI_{cw}$, $cII_{cw}$, $cIII_{cw}$, and $cIV_{cw}$ can be arranged in a left end portion of the check matrix H.

$$H = \begin{bmatrix} \begin{matrix} ELHP_{(cw'=4,\ rw'=4)} \\ cI_{cw} \quad 0\ 0\ 0 \\ cVI_{cw} \quad 0\ 0\ 0 \\ cIII_{cw} \quad 0\ 0\ 0 \\ cII_{cw} \quad 0\ 0\ 0 \end{matrix} & \begin{matrix} \diagdown & 0 & 0 & 0 & 0 & 0 & 0 & 0 \\ 0 & \diagdown & 0 & 0 & 0 & 0 & 0 & 0 \\ 0 & 0 & \diagdown & 0 & 0 & 0 & 0 & 0 \\ 0 & 0 & 0 & \diagdown & 0 & 0 & 0 & 0 \\ 0 & 0 & 0 & 0 & \diagdown & 0 & 0 & 0 \\ 0 & 0 & 0 & 0 & 0 & \diagdown & 0 & 0 \\ 0 & 0 & 0 & 0 & 0 & 0 & \diagdown & 0 \\ 0 & 0 & 0 & 0 & 0 & 0 & 0 & \diagdown \end{matrix} \end{bmatrix}$$

The combination of degree distributions which can be adopted serves as a restriction condition imposed on the optimization of the degree distribution of generation of the check matrix.

In step ST45, the degree distribution optimizing unit 45 optimizes the degree distribution of generation of a check matrix by means of either a density evolution method or a Multi-edge type density evolution method by imposing, as a restriction condition, the combination of the degree distributions which can be adopted, which is determined in above-mentioned step ST44, on the optimization of the degree distribution of generation of the check matrix.

That is, under the restriction condition that the combination of degree distributions which can be adopted for the optimization of the degree distribution of generation of a check matrix, which is determined in above-mentioned step ST44, the degree distribution optimizing unit can calculate the best degree distribution through optimization processing similar to that of the degree distribution as shown in step ST15 of embodiment 1, or can calculate the best degree distribution using a Multi-edge type density evolution method as will be explained below.

In accordance with the density evolution method described in above-mentioned embodiment 1, an ensemble of Irregular LDPC codes (indicating a degree distribution) is expressed as the fraction of the row degree and the fraction of the column degree. In contrast, in accordance with the Multi-edge type density evolution method, an ensemble of Multi-edge type LDPC codes is expressed as the fraction of a "combination of edges (edge types)" (degree type). In the framework of an ensemble of Multi-edge type LDPC codes, an ensemble for which up to which bit should be punctured is defined can be considered, and a consideration according to the communication path type can be made (see "Multi-Edge Type LDPC Codes DRAFT", T.Richardson, R.Urbanke, on the Web).

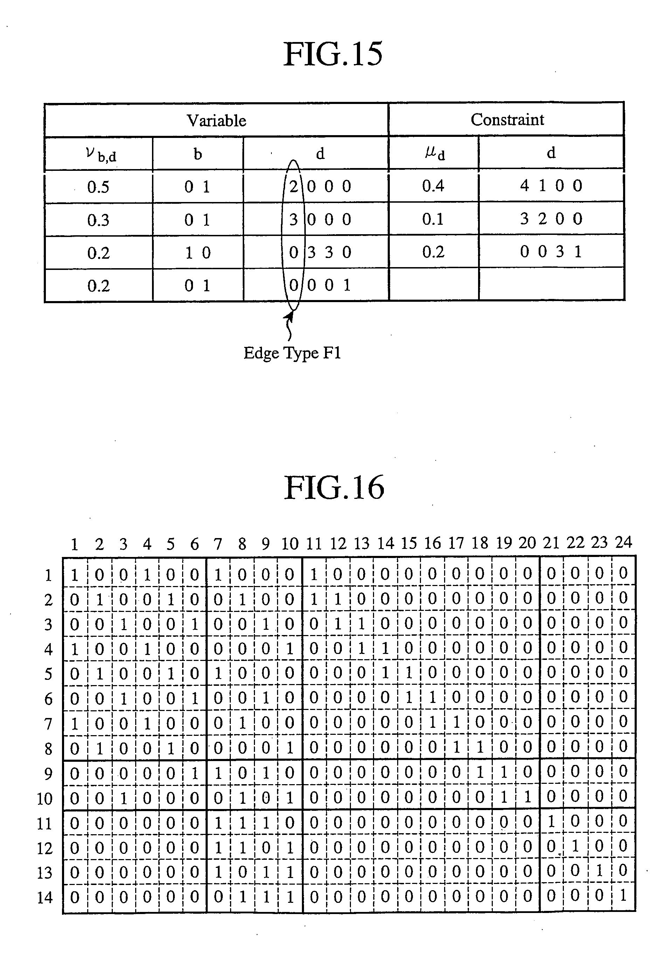

Fig. 14 is a diagram showing an example of an ensemble of Multi-edge type LDPC codes. By expressing a communication path (b= (10)) of a communication path type (in the case of the example of Fig. 14, BEC (Binary Erasure Channel) type) or a communication path to which noise according to a Gaussian distribution with variance $\sigma_n^2$ is added, i.e., a so-called additivity white Gaussian noise (AWGN) type of communication path (b= (0 1)) as b, expressing the fraction of variable nodes with the degree type d for the code length N as $v_{b,d}$, and expressing the fraction of check nodes with the degree type d for the code length N as $\mu_d$, Fig. 14 can be expressed as a table shown in Fig. 15.

Fig. 15 is a diagram showing an example of the degree distribution of irregular LDPC codes.

An example of a concrete check matrix will be shown below. For example, the sum of $v_{b,d}$ in Variable (i.e., variable nodes: each column of the matrix is a variable node) with b= (1 0) in the table of Fig. 15 is equal to 1. The ratio shown on the top of Variable in the table of Fig. 15 is $v_{b,d}$=0.5, and d=(2 0 0 0), and these values represent the *15*th through 24th columns of the check matrix shown in Fig. 16 which is constructed according to the degree distribution of Fig. 15. In the third row of Variable in the table of Fig. 15, $v_{b,d}$= 0.2, b= (1 0), and d= (0 3 3 0) are shown, and these values represent the *11*th through *14*th columns of the check matrix shown in Fig. 16. This portion means a communication path with a disappearance probability 1. Actually, the sign bit of this portion is punctured and is not transmitted. On the receive side, this portion is calculated with the probabilities of 0 and 1 being all set to 1/2. The LLR (log-likelihood ratio) of the received value becomes zero.

Constraint in the table of Fig. 15 shows the ratio of each check node (each row of the matrix is a check node). The ratio shown on the top of Constraint in the table of Fig. 15 is $\mu_d$=0.4 and d= (4 1 0 0), and these values represent the 5th through 12th rows of the check matrix of Fig. 16.

The percentage of edges which are connected to a node with the degree type d in edges of type i is determined according to the following equations:

[Equation 57]

$$\text{Variable node}: \frac{n * d_i v_{b,d}(\text{the number of edges of type i with degree type d})}{n * \sum_d d_j v_{b,d}(\text{the total number of edges of type i})} = \frac{d_i v_{b,d}}{v_{x_i}(1,1)}$$

$$\text{Check node}: \frac{n * d_i \mu_d(\text{the number of edges of type i with degree type d})}{n * \sum_d d_i \mu_d(\text{the total number of edges of type i})} = \frac{d_i \mu_d}{\mu_{x_i}(1)}$$

(which correspond to $\lambda$ and $\rho$ of Standard Irregular LDPC, respectively).
In these equations, 1 shows ALL1.

Next, the Multi-edge type density evolution method will be explained. In accordance with the Multi-edge type density evolution method, while messages from variable nodes to check nodes are not brought together, calculations are implemented in such a way that a probability density function is provided for each edge type ("Multi-Edge Type LDPC Codes DRAFT", T.Richardson, R.Urbanke, on the Web).

Row processing (messages from check nodes)

[Equation 58]

The set of all edge types is expressed as I.
Furthermore, for $i \in$ I, the degree of the edge type i is expressed as $d_i$, a probability density function transmitted to a check node via an edge of edge type i is expressed as $p_{vi}$, and a probability density function transmitted from a check node via an edge of edge type i is expressed as $p_{ui}$.
A probability density function is calculated for each degree type, the probability density function is multiplied by the fraction of an edge corresponding to an edge type i, and the probability density functions calculated for all degree types are summed, so that the probability density function for each edge type is calculated.

[Equation 59]

$$p_{u_i} = \sum_d \frac{d_i \mu_d}{\mu_{x_i}(1)} \Re(\Re(\Re^{d_i-1} p_{v_i}, \Re^{d_j} p_{v_j}), \ldots) \quad (\Re(a,b) = Q\left(2 \tanh^{-1}\left(\tanh\frac{a}{2}\tanh\frac{b}{2}\right)\right))$$

$$\cdots (\text{A1})$$

When the number of iterations in the iteration decoding is expressed as $l$ and the ensemble mean of the check nodes at the $l$th iteration for the edge type $i$ is expressed as A, the satisfaction of the following condition is a necessary condition under which the error approaches 0 asymptotically and infinitely during the iteration decoding using the sum product decoding method.
For all the edge types i,

$$m_{p_{\mu i}(l)} > m_{p_{\mu i}(l-1)}, \quad \forall l \in R^+. \quad \cdots (\text{A2})$$

Column processing (messages from variable nodes)

[Equation 60]

The degrees for the communication path types b1 and b2 are expressed as $d_{b1}$ and $d_{b2}$, respectively, and the initial values are expressed as A, respectively.

A probability density function is calculated for each degree type, the probability density function is multiplied by the fraction of an edge corresponding to an edge type i, and the probability density functions calculated for all degree types are summed, so that the probability density function for each edge type is calculated.

[Equation 61]

$$p_{v_i} = \sum_d \frac{d_i v_{b,d}}{v_{x_i}(1,1)} \left(\otimes^{d_a} p_{\mu 0_{b1}}\right) * \left(\otimes^{d_b} p_{\mu 0_{b2}}\right) * \cdots \left(\otimes^{d_i-1} p_{\mu_i}\right) * \left(\otimes^{d_j} p_{\mu_j}\right) * \cdots, \quad \forall j \in I \setminus i \quad \cdots (A3)$$

When the number of iterations in the iteration decoding is expressed as *1* and the ensemble mean of the check nodes at the *1*th iteration for the edge type i is expressed as A, the satisfaction of the following condition is a necessary condition under which the error approaches 0 asymptotically and infinitely during the iteration decoding using the sum product decoding method.

For all the edge types i,

$$m_{p_{v_i}(l)} > m_{p_{v_i}(l-1)}, \quad \forall l \in R^+. \quad \cdots (A4)$$

The satisfaction of the following condition is the necessary and sufficient condition on which the error approaches 0 asymptotically and infinitely during iteration decoding using the sum product decoding method.

Either the equation (A2) or the equation (A4) should be satisfied ... (A5)

Next, the ensemble (i.e., the degree distribution) of "Irregular-LDPC codes" which is based on a requested coding rate is calculated through the optimization of the Multi-edge type density evolution method.

The fraction of variable nodes with the communication path type b and the degree type d for the code length N is expressed as $v_{b,d}$, the fraction of check nodes for the code length N is expressed as $\mu_d$, and they are simultaneously handled as variables. Optimal $v_{b,d}$ and $\mu_d$ are then searched for with linear programming so that the Gauss noise $\sigma_n$ (given by the below equation) of the AWGN communication path (b1 of the communication path type AWGN:=b=(01)) is maximized. In this case, in accordance with this embodiment, the communication path types include only AWGN with b1:=b= (01) and BEC with b2 : =b= (1 0).

[Equation 62]

$$P_{\mu 0_{hj}} = \frac{1}{\sqrt{2\pi\sigma_n^2}} exp\left[-\frac{(x-m_{\mu 0_{hj}})^2}{2\sigma^2}\right]$$

The restriction condition imposed on this search is the satisfaction of the conditional expression (A5).

In this case, the values which the variables: the communication path type b, the degree type d, $v_{b,d}$, and $\mu_d$ can have are only values which are derived on the restriction condition imposed on the check matrix H which is generated by means of the generation method described in either of embodiments 1 to 4.

In step ST46, according to the degree distribution of generation of a check matrix, which is optimized in above-mentioned step ST45, the check matrix generating unit 46 arranges the third and second pseudo-random-number permutation matrices generated in above-mentioned step ST43 so as to generate a check matrix for LDPC codes.

[Equation 63]

In this case, by using the combination of the optimal degree distributions calculated in step ST43, the check matrix H is generated from the third pseudo-random number permutation matrix $ELHP_{(cw',rw')}$, and the second pseudo-random number permutation matrices $cI_{cw}$, $cII_{cw}$, $cIII_{cw}$, and $cIV_{cw}$. A proper position of each pseudo random number permutation matrix is determined by checking the number of cycles through search and so on.

Results of evaluation of the performance of LDPC codes using the code configuration method according to either of embodiments 3 and 4 will be shown below.

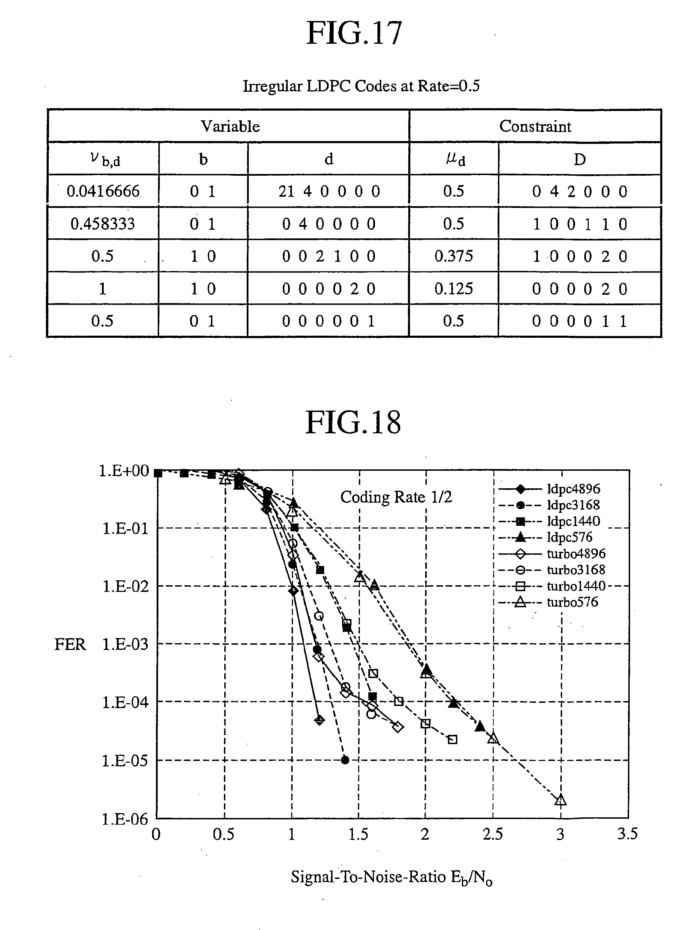

Fig. 17 is a diagram showing an example of the degree distribution of irregular LDPC codes used for the evaluation.
Fig. 18 is a diagram showing the frame error rate characteristics of irregular LDPC codes.

[Equation 64]

Fig. 18 shows FER (frame error rate) simulation results of an LDPC code with an information length of 576 bits and a coding rate of 0.5 (ldpc576 in the diagram) according to embodiment 3, which is formed according to the following parameters: $p$=16, $b$=9, $P$=17, $G_0$=3, $init$=9, and $hop$=2, using the degree distribution shown in Fig. 17, an LDPC code with an information length of 1,440 bits and a coding rate of 0.5 (ldpc1440 in the diagram) according to embodiment 4, which is formed according to the following parameters for $ELHP_{(cw,rw)}$: $p$=48, $b$=30, $P$=71, $G_0$=7, $init$=13, $cw$=4, and $rw$=4, and according to the following parameters for $cl_{cw}$, $cll_{cw}$, $clll_{cw}$, and $clV_{cw}$: $p$=30, $b$=12, $P$=31, $G_0$=3, $init$=9, and $hop$=1, an LDPC code with an information length of 3,168 bits and a coding rate of 0.5 (ldpc3168 in the diagram) according to embodiment 4, which is formed according to the following parameters for $ELHP_{(cw,rw)}$: $p$=132, $b$=24, $P$=137, $G_0$=3, $init$=13, $cw$=4, and $rw$=4, and according to the following parameters for $cl_{cw}$, $cll_{cw}$, $clll_{cw}$, and $clV_{cw}$: $p$=33, $b$=34, $P$=53, $G_0$=3, $init$=9, and $hop$=2, and an LDPC code with an information length of 4,896 bits and a coding rate of 0.5 (ldpc4896 in the diagram) according to embodiment 4, which is formed according to the following parameters for $ELHP_{(cw,rw)}$ : $p$=204, $b$=24, $P$=211, $G_0$=3, $init$=13, $cw$=4, and $rw$=4, and according to the following parameters for $cl_{cw}$, $cll_{cw}$, $clll_{cw}$, and $clV_{cw}$: $p$=51, $b$=24, $P$=53, $G_0$=3, $init$=9, and $hop$=2.
In Fig. 18, turbo codes with the same code lengths as the irregular LDPC codes and with the same coding rate as the irregular LDPC codes, which are used for third generation communication (3GPP), are shown as comparison objects (turbo576, turbo1440, turbo3168, and turbo4896). As can be seen from Fig. 18, although it is said that turbo codes hold superiority over irregular LDPC codes at short code lengths shorter than 10000 bits, the LDPC codes proposed by the present invention offer much the same performance as the turbo codes at 576 bits of information length, and always offer performance superior to that of the turbo codes at any information length longer than 576 bits of information length, and it can be therefore recognized that the code configuration method according to the present invention offers very high performance.
It is said that prior art LDPC codes offer better performance at a code length of 10,000 bits or more, whereas turbo codes offer better performance at a code length of 10,000 bits or less. However, as can be seen from Fig. 18, the LDPC codes according to the present invention offer better performance than the turbo codes at an information length of 4,896 bits (i.e., at a code length of 9,792 bits because the coding rate is 0.5). Furthermore, the LDPC codes according to the present invention show a tendency to have performance which becomes better than that of the turbo codes as their code lengths become long. Although prior art LDPC codes offer much the same performance as turbo codes at about a code length of 10, 000 bits, the LDPC codes according to the present invention offer much the same performance as the turbo codes at about a code length of 1,000 bits (i.e. , an information length of 576 bits in Fig. 18 because the coding rate is 0.5).
As mentioned above, this embodiment 4 offers the same advantage as provided by embodiment 1, and offers another advantage of being able to generate a check matrix of LDPC codes having a further-enhanced error correction capability by means of the Multi-edge type density evolution method.

Embodiment 5.

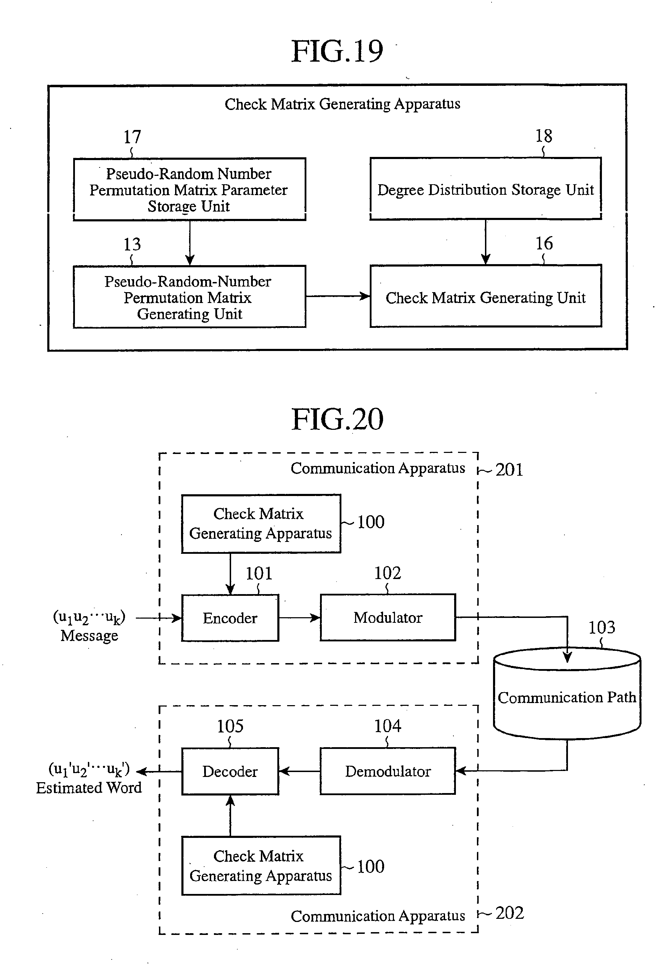

Fig. 19 is a block diagram showing the structure of a check matrix generating apparatus for LDPC codes in accordance with embodiment 5 of the present invention. The check matrix generating apparatus of this embodiment 5 is provided with a pseudo-random-number permutation matrix generating unit 13, a check matrix generating unit 16, a pseudo-random-number permutation matrix parameter storage unit 17, and a degree distribution storage unit 18. This check matrix generating apparatus can be mounted in each of the communication apparatus on the transmit side of the system shown in Fig. 4 and that on the receive side of the system so that they can output generated check matrices to the encoder 101 and decoder 105, respectively. As an alternative, the check matrix generating apparatus can be mounted outside each of the communication apparatus on the transmit side of the system and that on the receive side of the system so that they can store generated check matrices in memories (not shown) in the communication apparatus on the transmit and receive sides of the system and output them to the encoder 101 and decoder 105, respectively.
In Fig. 19, the pseudo-random number permutation matrix parameter storage unit 17 stores a parameter for pseudo-random number permutation matrices which is calculated using a predetermined information length, a coding rate, and a maximum column degree. This parameter for pseudo-random-number permutation matrices is generated outside the check matrix generating apparatus, as in the case of embodiment 1. The pseudo-random-number permutation matrix generating unit 13 generates pseudo-random number permutation matrices from the parameter for pseudo-random number permutation matrices which is stored in the pseudo-random number permutation matrix parameter storage unit 17 using a pseudo-random number sequence and a Latin square matrix.

The degree distribution storage unit 18 stores the degree distribution of generation of a check matrix which is optimized by means of a density evolution method on which a combination of degree distributions which can be adopted for optimization of the degree distribution of generation of a check matrix which can be constructed using the pseudo-random-number permutation matrices, which are determined using the predetermined information length, coding rate, and maximum column degree, is imposed, as a restriction condition, on the optimization of the degree distribution of generation of the check matrix. The degree distribution of generation of a check matrix is optimized outside the check matrix generating apparatus, as in the case of embodiment 1. The check matrix generating unit 16 then arranges the generated pseudo-random number permutation matrices according to the optimized degree distribution of generation of a check matrix which is stored in the degree distribution storage unit 18 so as to generate a check matrix for low-density parity-check codes.

The check matrix generating apparatus in accordance with this embodiment 5 is provided with the pseudo-random-number permutation matrix generating unit 13 and check-matrix generating unit 16 of embodiment 1, and the pseudo-random number permutation matrix parameter storage unit 17 and degree distribution storage unit 18, as mentioned above. As an alternative, the check matrix generating apparatus in accordance with this embodiment can be provided with the pseudo-random-number permutation matrix generating unit 23 and check-matrix generating unit 26 of embodiment 2, and a pseudo-random number permutation matrix parameter storage unit 27 and a degree distribution storage unit 28 (not shown), the pseudo-random-number permutation matrix generating unit 33 and check-matrix generating unit 36 of embodiment 3, and a pseudo-random number permutation matrix parameter storage unit 37 and a degree distribution storage unit 38 (not shown), or the pseudo-random-number permutation matrix generating unit 43 and check-matrix generating unit 46 of embodiment 4, and a pseudo-random number permutation matrix parameter storage unit 47 and a degree distribution storage unit 48 (not shown).

As can be seen from the above description, this embodiment 5 can offer the same advantages as provided by embodiment 1.

Embodiment 6.

Fig. 20 is a block diagram showing the structure of communication apparatus in accordance with embodiment 6 of the present invention. A communication apparatus 201 on a transmit side is provided with a check matrix generating apparatus 100 according to either of embodiments 1 to 5, an encoder 101, and a modulator 102, while a communication apparatus 202 on a receive side is provided with a check matrix generating apparatus 100 according to either of embodiments 1 to 5, a demodulator 104, and a decoder 105.

In the communication apparatus 201 on the transmit side, the check matrix generating apparatus 100 generates a check matrix H by means of a method according to either of embodiments 1 to 5, the encoder 101 calculates a generator matrix G using the generated check matrix H, receives a message $(u_1 u_2 ... u_K)$, and generates a code word C using the calculated generator matrix G. The modulator 102 performs a digital modulation, such as BPSK, QPSK, or multiple-value QAM, on the generated code word C, and transmits the digital-modulated code word.

In the communication apparatus 202 on the receive side, the check matrix generating apparatus 100 generates a check matrix H by means of a method according to either of embodiments 1 to 5, the demodulator 104 performs a digital demodulation, such as BPSK, QPSK, or multiple-value QAM, on the modulation signal received via a communication path 103, the decoder 105 performs iteration decoding based on a "sum-product algorithm" on the demodulated result which is LDPC-coded using the generated check matrix, and outputs an estimation result (corresponds to the original message $u_1 u_2 ... u_k$).

As mentioned above, this embodiment 6 offers an advantage of being able to use a check matrix for "Irregular-LDPC codes" which is deterministic, which has stable characteristics, which has a good error correction capability, and which supports various ensembles, various code lengths, and various coding rates by using the check matrix generating apparatus 100 according to either of embodiments 1 to 5.

Industrial Applicability

As mentioned above, the check matrix generating apparatus and check matrix generating method in accordance with the present invention are suitable for, for example, apparatus which easily generate a check matrix for Irregular-LDPC codes which is deterministic, which have stable characteristics, which has a good error correction capability, and which supports various ensembles, various code lengths, and various coding rates in a short time.

**Claims**

1. A check matrix generating apparatus comprising:

an information length, coding rate, and maximum column degree input unit for inputting a predetermined information length, a coding rate, and a maximum column degree;

a pseudo-random-number permutation matrix parameter calculating unit for calculating a parameter for below-mentioned pseudo-random-number permutation matrices using said inputted predetermined information length, said inputted coding rate, and said inputted maximum column degree;

a pseudo-random-number permutation matrix generating unit for generating said pseudo-random-number permutation matrices from the calculated parameter for said pseudo-random-number permutation matrices by using a pseudo-random-number sequence and a Latin square matrix;

a degree distribution optimization parameter calculating unit for determining, as a parameter, a combination of degree distributions which can be adopted for optimization of a degree distribution of generation of a check matrix which can be formed with said pseudo-random-number permutation matrices, using said inputted predetermined information length, said inputted coding rate, and said inputted maximum column degree;

a degree distribution optimizing unit for optimizing the degree distribution of generation of the check matrix using a density evolution method by imposing, as a restriction condition, said determined combination of degree distributions which can be adopted, on the optimization of the degree distribution of generation of the check matrix; and

a check matrix generating unit for arranging said generated pseudo-random-number permutation matrices according to said optimized degree distribution of generation of the check matrix so as to generate the check matrix for low-density parity-check codes.

2. The check matrix generating apparatus according to claim 1, **characterized in that** said information length, coding rate, and maximum column degree input unit inputs the predetermined information length, two or more coding rates, and a maximum column degree of a maximum coding rate except non-coding, said pseudo-random-number permutation matrix parameter calculating unit calculates the parameter for said pseudo-random-number permutation matrices using said inputted predetermined information length, said inputted two or more coding rates, and said inputted maximum column degree of the maximum coding rate except non-coding, and said degree distribution optimization parameter calculating unit determines, as the parameter, the combination of degree distributions which can be adopted for optimization of the degree distribution of generation of the check matrix which can be formed with said pseudo-random-number permutation matrices, using said inputted predetermined information length, said inputted two or more coding rates, and said inputted maximum column degree of the maximum coding rate except non-coding.

3. The check matrix generating apparatus according to claim 1, **characterized in that** said pseudo-random-number permutation matrix parameter calculating unit calculates a parameter for first and the second pseudo-random-number permutation matrices, which will be mentioned below, using said inputted predetermined information length, said inputted coding rate, and said inputted maximum column degree, said pseudo-random-number permutation matrix generating unit generates said first pseudo-random-number permutation matrices from the calculated parameter for said first and second pseudo-random-number permutation matrices using the pseudo-random-number sequence and the Latin square matrix, and further compresses said first pseudo-random-number permutation matrices in a direction of rows so as to generate said second pseudo-random-number permutation matrices, said degree distribution optimization parameter calculating unit determines, as the parameter, the combination of degree distributions which can be adopted for optimization of the degree distribution of generation of the check matrix which can be formed with said first and second pseudo-random-number permutation matrices, using said inputted predetermined information length, said inputted coding rate, and said inputted maximum column degree, and said check matrix generating unit arranges said generated first and second pseudo-random-number permutation matrices according to said optimized degree distribution of generation of a check matrix so as to generate the check matrix for low-density parity-check codes.

4. The check matrix generating apparatus according to claim 1, **characterized in that** said pseudo-random-number permutation matrix parameter calculating unit calculates a parameter for a third pseudo-random-number permutation matrix, which will be mentioned below, and a parameter for second pseudo-random-number permutation matrices, which will be mentioned below, using said inputted predetermined information length, said inputted coding rate, and said inputted maximum column degree, said pseudo-random-number permutation matrix generating unit further interchanges the rows and columns of the first pseudo-random number permutation matrices generated using the pseudo-random-number sequence and the Latin square matrix according to the calculated parameter for said third pseudo-random-number permutation matrix, and the calculated parameter for said second pseudo-random-number permutation matrices, thereby extending the first pseudo-random number permutation matrices, so as to generate the above-mentioned third pseudo-random-number permutation matrix, and further compresses said first pseudo-random-number permutation matrices in a direction of rows so as to generate said second pseudo-random-number permutation matrices, said degree distribution optimization parameter calculating unit determines, as a parameter, a combination of degree distributions which can be adopted for optimization of the degree distribution of generation of the check matrix which can be formed with said third and second pseudo-random-number permutation matrices, using said inputted predetermined information length, said inputted coding rate, and said inputted maximum column degree; said degree distribution optimizing unit optimizes the degree distribution of generation of the check matrix using either the density evolution method or a Multi-edge type density evolution method by imposing, as a restriction condition, said determined combination of degree distributions which can be adopted, on the optimization of the degree distribution of generation of the check matrix, and said check matrix generating unit arranges said generated third and second pseudo-random-number permutation matrices according to said optimized degree distribution of generation of the check matrix so as to generate the check matrix for low-density parity-check codes.

5. The check matrix generating apparatus according to claim 1, **characterized in that** the check matrix which are generated as a result of arranging said pseudo-random number permutation matrices by said check-matrix generating unit has cycles which are of order of six and higher.

6. A check matrix generating apparatus comprising:

   a pseudo-random-number permutation matrix generating unit for inputting a parameter for pseudo-random-number permutation matrices which is calculated using a predetermined information length, a coding rate, and a maximum column degree, and for generating said pseudo-random-number permutation matrices using a pseudo-random-number sequence and a Latin square matrix; and
   a check matrix generating unit for inputting a degree distribution of generation of a check matrix which is optimized by means of a density evolution method under a restriction condition which defines a combination of degree distributions which can be adopted for the optimization of the degree distribution of generation of the check matrix which can be formed with said pseudo-random-number permutation matrices, using said predetermined information length, said coding rate, and said maximum column degree, and for arranging the generated above-mentioned pseudo-random number permutation matrices so as to generate the check matrix for low-density parity-check codes.

7. A communication apparatus comprising:

   a check matrix generating apparatus according to claim 1; and
   an encoder for acquiring a generator matrix using a check matrix generated by said check matrix generating apparatus so as to generate a code word.

8. A communication apparatus comprising:

   a check matrix generating apparatus according to claim 1; and
   a decoder for carrying out iteration decoding according to a sum-product algorithm using a check matrix generated by said check matrix generating apparatus so as to calculate an estimation result.

9. A communication apparatus comprising:

   a check matrix generating apparatus according to claim 6; and
   an encoder for acquiring a generator matrix using a check matrix generated by said check matrix generating apparatus so as to generate a code word.

10. A communication apparatus comprising:

   a check matrix generating apparatus according to claim 6; and
   a decoder for carrying out iteration decoding according to a sum-product algorithm using a check matrix generated by said check matrix generating apparatus so as to calculate an estimation result.

# FIG.1

Blanks show Zero

Block in Which the Columns Are Permutated Randomly

Block in Which the Columns Are Permutated Randomly

# FIG.2

# FIG.3

# FIG.4

# FIG.5

**Check Matrix Generating Apparatus**

11
| Information Length, Coding Rate, and Maximum Column Degree Input Unit |

12
| Pseudo-Random-Number Permutation Matrix Parameter Calculating Unit |

13
| Pseudo-Random-Number Permutation Matrix Generating Unit |

14
| Degree Distribution Optimization Parameter Calculating Unit |

15
| Degree Distribution Optimizing Unit |

16
| Check Matrix Generating Unit |

# FIG.7

**Check Matrix Generating Apparatus**

21
| Information Length, Coding Rate, and Maximum Column Degree Input Unit |

22
| Pseudo-Random-Number Permutation Matrix Parameter Calculating Unit |

23
| Pseudo-Random-Number Permutation Matrix Generating Unit |

24
| Degree Distribution Optimization Parameter Calculating Unit |

25
| Degree Distribution Optimizing Unit |

26
| Check Matrix Generating Unit |

# FIG.6

Start

Input an Information Length, a Coding Rate, and a Maximum Column Degree ~ST11

Calculate Parameters for Pseudo-Random Number Permutation Matrices ~ST12

Generate the Pseudo-Random Number Permutation Matrices Using a Pseudo-Random Number Sequence and a Latin Square Matrix ~ST13

Determine, As a Parameter, a Combination of Degree Distributions Which Can Be Adopted for Optimization of the Degree Distribution of Generation of a Check Matrix ~ST14

Optimize the Degree Distribution by Means of the Density Evolution Method by Imposing, As a Restriction Condition, the Combination of Degree Distributions Which Can Be Adopted, on the Optimization of the Degree Distribution of Generation of a Check Matrix ~ST15

Arrange the Pseudo-Random Number Permutation Matrices So As To Generate a Check Matrix ~ST16

End

# FIG.8

```
                    ┌──────────┐
                    │  Start   │
                    └──────────┘
                         │
                         ▼
┌────────────────────────────────────────────────┐
│ Input an Information Length, Two or More Coding  │   ST21
│ Rates, and a Maximum Degree of Column of a       │
│ Maximum Coding Rate Except Non-Coding            │
└────────────────────────────────────────────────┘
                         │
                         ▼
┌────────────────────────────────────────────────┐
│ Calculate Parameters for Pseudo-Random Number    │   ST22
│ Permutation Matrices                             │
└────────────────────────────────────────────────┘
                         │
                         ▼
┌────────────────────────────────────────────────┐
│ Generate the Pseudo-Random Number Permutation    │   ST23
│ Matrices Using a Pseudo-Random Number Sequence   │
│ and a Latin Square Matrix                        │
└────────────────────────────────────────────────┘
                         │
                         ▼
┌────────────────────────────────────────────────┐
│ Determine, As a Parameter, a Combination of      │   ST24
│ Degree Distributions Which Can Be Adopted for    │
│ Optimization of the Degree Distribution of       │
│ Generation of a Check Matrix                     │
└────────────────────────────────────────────────┘
                         │
                         ▼
┌────────────────────────────────────────────────┐
│ Optimize the Degree Distribution for the Two or  │   ST25
│ More Coding Rates by Means of the Density         │
│ Evolution Method by Imposing, As a Restriction    │
│ Condition, the Combination of Degree              │
│ Distributions Which Can Be Adopted, on the        │
│ Optimization of the Degree Distribution of        │
│ Generation of a Check Matrix                      │
└────────────────────────────────────────────────┘
                         │
                         ▼
┌────────────────────────────────────────────────┐
│ Arrange the Pseudo-Random Number Permutation     │   ST26
│ Matrices So As To Generate a Check Matrix         │
└────────────────────────────────────────────────┘
                         │
                         ▼
                    ┌──────────┐
                    │   End    │
                    └──────────┘
```

# FIG.9

# FIG.10

# FIG.11

```
┌─────────┐
│  Start  │
└─────────┘
```

Input an Information Length, a Coding Rate, and a Maximum Column Degree  ~ST31

Calculate Parameters for First and Second Pseudo-Random Number Permutation Matrices  ~ST32

Generate the First Pseudo-Random Number Permutation Matrices Using a Pseudo-Random Number Sequence and a Latin Square Matrix, and Compress the First Pseudo-Random Number Permutation Matrices in a Direction of Rows So As To Generate the Second Pseudo-Random Number Permutation Matrices  ~ST33

Determine, As a Parameter, a Combination of Degree Distributions Which Can Be Adopted for Optimization of the Degree Distribution of Generation of a Check Matrix  ~ST34

Optimize the Degree Distribution by Means of the Density Evolution Method by Imposing, As a Restriction Condition, the Combination of Degree Distributions Which Can Be Adopted, on the Optimization of the Degree Distribution of Generation of a Check Matrix  ~ST35

Arrange the First and Second Pseudo-Random Number Permutation Matrices So As To Generate a Check Matrix  ~ST36

```
┌─────────┐
│   End   │
└─────────┘
```

# FIG.12

APPARATUS

41

Information Length,
Coding Rate, and Maximum
Column Degree Input Unit

44

Degree Distribution
Optimization Parameter
Calculating Unit

42

Pseudo-Random-Number
Permutation Matrix Parameter
Calculating Unit

45

Degree Distribution
Optimizing Unit

43

Pseudo-Random-Number
Permutation Matrix
Generating Unit

46

Check Matrix Generating Unit

# FIG.14

Puncture Bit

Variable Node

50%    30%    20%    20%

Edge Type 1    Edge Type 2    Edge Type 3    Edge Type 4

40%    10%    20%

Check Node

# FIG.13

Start

↓

Input an Information Length, a Coding Rate, and a Maximum Column Degree ~ ST41

↓

Calculate Parameters for Second and Third Pseudo-Random Number Permutation Matrices ~ ST42

↓

Generate First Pseudo-Random Number Permutation Matrices Using a Pseudo-Random Number Sequence and a Latin Square Matrix, Interchange the Rows and Columns of the First Pseudo-Random Number Permutation Matrices, thereby Extending the First Pseudo-Random Number Permutation Matrices, So As To Generate a Third Pseudo-Random Number Permutation Matrix, and Compresses the First Pseudo-Random Number Permutation Matrices in the Direction of Rows So As To Generate the Second Pseudo-Random Number Permutation Matrices ~ ST43

↓

Determine, As a Parameter, a Combination of Degree Distributions Which Can Be Adopted for Optimization of the Degree Distribution of Generation of a Check Matrix ~ ST44

↓

Optimize the Degree Distribution by Means of a Density Evolution Method or a Multi-Edge Type Density Evolution Method by Imposing, As a Restriction Condition, the Combination of Degree Distributions Which Can Be Adopted, on the Optimization of the Degree Distribution of Generation of a Check Matrix ~ ST45

↓

Arrange the Third and Second Pseudo-Random Number Permutation Matrices So As To Generate a Check Matrix ~ ST46

↓

End

# FIG.15

| Variable | | | Constraint | |
|---|---|---|---|---|
| $\nu_{b,d}$ | b | d | $\mu_d$ | d |
| 0.5 | 0 1 | 2 0 0 0 | 0.4 | 4 1 0 0 |
| 0.3 | 0 1 | 3 0 0 0 | 0.1 | 3 2 0 0 |
| 0.2 | 1 0 | 0 3 3 0 | 0.2 | 0 0 3 1 |
| 0.2 | 0 1 | 0 0 0 1 | | |

Edge Type F1

# FIG.16

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
|---|---|---|---|---|---|---|---|---|---|---|---|---|---|---|---|---|---|---|---|---|---|---|---|---|
| 1 | 1 | 0 | 0 | 1 | 0 | 0 | 1 | 0 | 0 | 0 | 1 | 0 | 0 | 0 | 0 | 0 | 0 | 0 | 0 | 0 | 0 | 0 | 0 | 0 |
| 2 | 0 | 1 | 0 | 0 | 1 | 0 | 0 | 1 | 0 | 0 | 1 | 1 | 0 | 0 | 0 | 0 | 0 | 0 | 0 | 0 | 0 | 0 | 0 | 0 |
| 3 | 0 | 0 | 1 | 0 | 0 | 1 | 0 | 0 | 1 | 0 | 0 | 1 | 1 | 0 | 0 | 0 | 0 | 0 | 0 | 0 | 0 | 0 | 0 | 0 |
| 4 | 1 | 0 | 0 | 1 | 0 | 0 | 0 | 0 | 0 | 1 | 0 | 0 | 1 | 1 | 0 | 0 | 0 | 0 | 0 | 0 | 0 | 0 | 0 | 0 |
| 5 | 0 | 1 | 0 | 0 | 1 | 0 | 1 | 0 | 0 | 0 | 0 | 0 | 0 | 1 | 1 | 0 | 0 | 0 | 0 | 0 | 0 | 0 | 0 | 0 |
| 6 | 0 | 0 | 1 | 0 | 0 | 1 | 0 | 0 | 1 | 0 | 0 | 0 | 0 | 0 | 1 | 1 | 0 | 0 | 0 | 0 | 0 | 0 | 0 | 0 |
| 7 | 1 | 0 | 0 | 1 | 0 | 0 | 0 | 1 | 0 | 0 | 0 | 0 | 0 | 0 | 0 | 1 | 1 | 0 | 0 | 0 | 0 | 0 | 0 | 0 |
| 8 | 0 | 1 | 0 | 0 | 1 | 0 | 0 | 0 | 0 | 1 | 0 | 0 | 0 | 0 | 0 | 0 | 1 | 1 | 0 | 0 | 0 | 0 | 0 | 0 |
| 9 | 0 | 0 | 0 | 0 | 0 | 1 | 1 | 0 | 1 | 0 | 0 | 0 | 0 | 0 | 0 | 0 | 0 | 1 | 1 | 0 | 0 | 0 | 0 | 0 |
| 10 | 0 | 0 | 1 | 0 | 0 | 0 | 0 | 1 | 0 | 1 | 0 | 0 | 0 | 0 | 0 | 0 | 0 | 0 | 1 | 1 | 0 | 0 | 0 | 0 |
| 11 | 0 | 0 | 0 | 0 | 0 | 0 | 1 | 1 | 1 | 0 | 0 | 0 | 0 | 0 | 0 | 0 | 0 | 0 | 0 | 0 | 1 | 0 | 0 | 0 |
| 12 | 0 | 0 | 0 | 0 | 0 | 0 | 1 | 1 | 0 | 1 | 0 | 0 | 0 | 0 | 0 | 0 | 0 | 0 | 0 | 0 | 0 | 1 | 0 | 0 |
| 13 | 0 | 0 | 0 | 0 | 0 | 0 | 1 | 0 | 1 | 1 | 0 | 0 | 0 | 0 | 0 | 0 | 0 | 0 | 0 | 0 | 0 | 0 | 1 | 0 |
| 14 | 0 | 0 | 0 | 0 | 0 | 0 | 0 | 1 | 1 | 1 | 0 | 0 | 0 | 0 | 0 | 0 | 0 | 0 | 0 | 0 | 0 | 0 | 0 | 1 |

# FIG.17

Irregular LDPC Codes at Rate=0.5

| Variable | | | Constraint | |
|---|---|---|---|---|
| $\nu_{b,d}$ | b | d | $\mu_d$ | D |
| 0.0416666 | 0 1 | 21 4 0 0 0 0 | 0.5 | 0 4 2 0 0 0 |
| 0.458333 | 0 1 | 0 4 0 0 0 0 | 0.5 | 1 0 0 1 1 0 |
| 0.5 | 1 0 | 0 0 2 1 0 0 | 0.375 | 1 0 0 0 2 0 |
| 1 | 1 0 | 0 0 0 0 2 0 | 0.125 | 0 0 0 0 2 0 |
| 0.5 | 0 1 | 0 0 0 0 0 1 | 0.5 | 0 0 0 0 1 1 |

# FIG.18

Coding Rate 1/2

Legend:
- ldpc4896
- ldpc3168
- ldpc1440
- ldpc576
- turbo4896
- turbo3168
- turbo1440
- turbo576

FER vs Signal-To-Noise-Ratio $E_b/N_o$

# FIG.19

Check Matrix Generating Apparatus

17

Pseudo-Random Number Permutation Matrix Parameter Storage Unit

18

Degree Distribution Storage Unit

13

Pseudo-Random-Number Permutation Matrix Generating Unit

16

Check Matrix Generating Unit

# FIG.20

Communication Apparatus $\sim$ 201

Check Matrix Generating Apparatus $\sim$ 100

101

$(u_1u_2\cdots u_k)$
Message

Encoder

102

Modulator

103

Communication Path

105

$(u_1'u_2'\cdots u_k')$
Estimated Word

Decoder

104

Demodulator

Check Matrix Generating Apparatus $\sim$ 100

Communication Apparatus $\sim$ 202

## INTERNATIONAL SEARCH REPORT

| International application No. |
| --- |
| PCT/JP2004/014958 |

**A. CLASSIFICATION OF SUBJECT MATTER**
Int.Cl$^7$ H03M13/09

According to International Patent Classification (IPC) or to both national classification and IPC

**B. FIELDS SEARCHED**

Minimum documentation searched (classification system followed by classification symbols)
Int.Cl$^7$ H03M13/00-13/53

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | Wataru MATSUMOTO et al., "LDPC Fugo Koseiho no Kiso to Oyo", The Institute of Electronics, Information and Communication Engineers 2003 Nen Kiso· Kyokai Society Taikai Koen Ronbunshu, 23 September, 2003 (23.09.03), SS17-SS18 | 1-10 |
| A | JP 2003-198383 A (Mitsubishi Electric Corp.), 11 July, 2003 (11.07.03), Full text; all drawings & WO 2003/056705 A1 | 1-10 |
| A | T.J. Richardson et al., The Capacity of Low-Density Parity-Check Codes Under Message-Passing Decoding, IEEE Transactions on Information Theory, February 2001, Vol.47, No.2, pages 599 to 618 | 1-10 |

☒ Further documents are listed in the continuation of Box C.　　☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 03 December, 2004 (03.12.04) | 21 December, 2004 (21.12.04) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

**INTERNATIONAL SEARCH REPORT**

International application No.

PCT/JP2004/014958

C (Continuation). DOCUMENTS CONSIDERED TO BE RELEVANT

| Category* | Citation of document, with indication, where appropriate, of the relevant passages | Relevant to claim No. |
|---|---|---|
| A | S.-Y. Chung et al., Analysis of Sum-Product Decoding of Low-Density Parity-Check Codes Using a Gaussian Approximation, IEEE Transactions on Information Theory, February 2001, Vol.47, No.2, pages 657 to 670 | 1-10 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **R.G. GALLAGER.** Low-Density Parity Check Codes. *IRE Trans. On IT,* January 1962, 21-28
- **Y. KOU ; S. LIN ; M. P. C. FOSSORIER.** Low Density Parity Check Codes Based on Finite Geometries: A Rediscovery and New Results. *IEEE Trans. Inform. Theory,* February 2001, vol. 47 (2), 2711-2736
- **M. G. LUBY ; M. MITZENMACHER ; M. A. SHOKROLLAHI ; D. A. SPIELMAN.** Improved Low-Density Parity-Check Codes Using Irregular Graphs and Belief Propagation. *Proceedings of 1998 IEEE International Symposium on Information Theory,* 16 August 1998, 171
- **T. J. RICHARDSON ; R. URBANKE.** The capacity of low-density parity-check codes under message-passing decoding. *IEEE Trans. Inform. Theory,* February 2001, vol. 47 (2), 599-618
- **S.-Y. CHUNG ; T. J. RICHARDSON ; R. URBANKE.** Analysis of Sum-Product Decoding of Low-Density Parity-Check Codes Using a Gaussian Approximation. *IEEE Trans. Inform. Theory,* February 2001, vol. 47 (2), 657-670
- **M. RASHIDPOUR ; S.H. JAMALI.** Low-Density Parity-Check Codes with Simple Irregular Semi-Random Parity Check Matrix $\times$ for Finite-Length Applications. *proc. IEEE PIMRC,* 2003, 439-443